# FASCICULE DE BREVET EUROPEEN

(11) **EP 3 671 815 B1**
(45) Date de publication et mention de la délivrance du brevet: **26.07.2023**
(21) Numéro de dépôt: 19218836.5
(22) Date de dépôt: 20.12.2019
(51) Int. Cl.: H01L 21/311, H01L 29/66

(54) **PROCÉDÉ DE GRAVURE D'UNE COUCHE DIÉLECTRIQUE TRIDIMENSIONNELLE**
GRAVURVERFAHREN EINER DIELEKTRISCHEN 3D-SCHICHT
METHOD FOR ETCHING A THREE-DIMENSIONAL DIELECTRIC LAYER

(30) Priorité: 20.12.2018 FR 1873686
(43) Date de publication de la demande: 24.06.2020
(73) Titulaire: Commissariat à l'Energie Atomique et aux Energies Alternatives, 75015 Paris (FR)
(72) Inventeur: POSSEME, Nicolas, 38054 GRENOBLE CEDEX 9 (FR); AH-LEUNG, Vincent, 38054 GRENOBLE CEDEX 9 (FR); POLLET, Olivier, 38054 GRENOBLE CEDEX 9 (FR)
(74) Mandataire: Hautier IP

(56) Documents cités:
- EP-A1- 3 107 118
- US-A1- 2016 079 396
- US-A1- 2017 358 502

## Description

### DOMAINE TECHNIQUE

La présente invention concerne en général la gravure de couches sur des structures microélectroniques, notamment tridimensionnelles (3D).

Elle trouve pour application particulièrement avantageuse la réalisation de transistors de type dit FinFET, c'est-à-dire de transistors à effet de champ (FET) dont le canal de conduction comprend une mince lamelle verticale d'un matériau semi-conducteur, qualifiée du terme anglais de « fin ».

### ÉTAT DE LA TECHNIQUE

Dans la course incessante à la réduction des dimensions qui caractérise toute l'industrie de la microélectronique, une difficulté particulière consiste à graver de manière précise une couche située sur certaines ou sur toutes les faces d'une structure 3D sans endommager ou consommer la structure 3D.

Tel est par exemple le cas pour la couche diélectrique destinée à former les espaceurs d'une grille d'un transistor de type FinFET et qui est déposée sur les Fins du transistor comme cela va être expliqué ci-dessous.

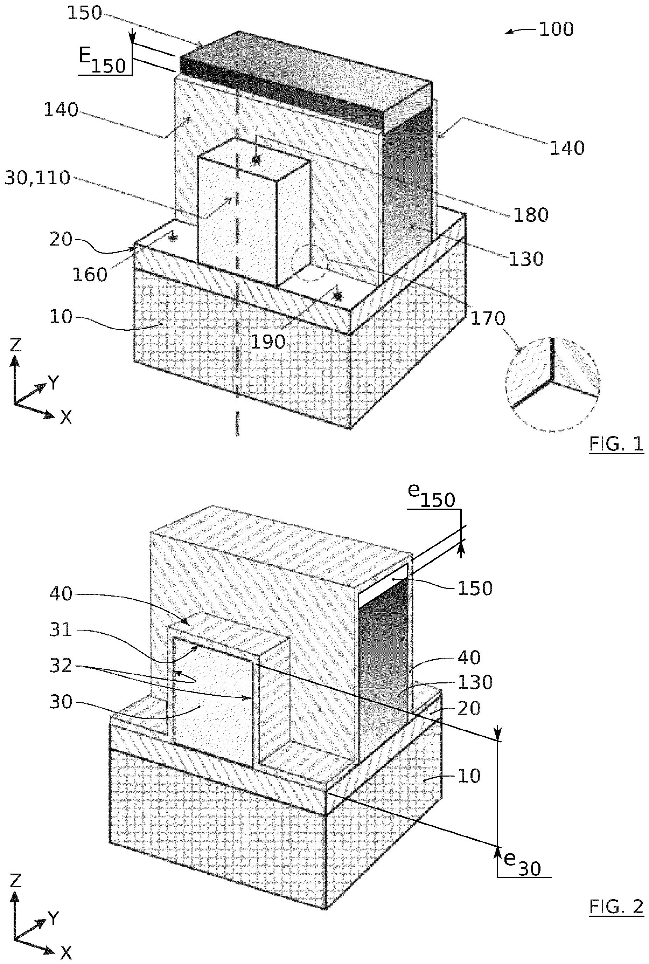

Un transistor 100 de type FinFET est illustré en figure 1. Dans ce dispositif tridimensionnel, le canal 110 de conduction est constitué d'une mince lamelle verticale de matériau semi-conducteur, typiquement du silicium. La lamelle formant le canal 110 est entourée sur trois côtés par la grille 130. La lamelle traverse de part en part la grille 130 et se prolonge pour former de part et d'autre de la grille 130 des nageoires ou «Fin» 30. Ces Fin constituent ainsi des structures tridimensionnelles (3D).

Par rapport aux transistors classiques, ces dispositifs FinFET permettent de réduire les courants de fuite et d'obtenir des transistors ayant de meilleures performances électriques. Le dispositif FinFET ci-dessus pourra être réalisé à partir d'un substrat SOI dont on retrouve la couche de protection enterré BOX 20 et le substrat 10 de support. On notera aussi la présence d'un masque dur 150 au sommet de la grille 130.

On notera que, selon d'autres modes de réalisation, de nombreux transistors FinFET sont fabriqués sur des substrats massifs (habituellement désignés par le vocable anglais « bulk »). Dans ce cas, la lamelle s'étend verticalement jusqu'au silicium du substrat massif. Le motif de grille repose quant à lui sur une couche diélectrique.

Quel que soit le substrat sur lequel il est fabriqué, le dispositif FinFET 100 exige que l'on sache réaliser des espaceurs 140 sur les flancs de la grille 130. Ces espaceurs 140 ont notamment pour fonction de protéger les flancs de la grille 130 lors de phases ultérieures d'implantation.

Pour former ces espaceurs 140, on effectue tout d'abord un dépôt d'une couche uniforme d'un matériau diélectrique sur toutes les surfaces du dispositif 100.

Comme cela est illustré sur la figure 1, on doit pouvoir obtenir par gravure que seuls des espaceurs 140 perpendiculaires au plan du substrat 10 restent en place de part et d'autre de la grille 130. Toutes les autres surfaces, en particulier celles couvrant le Fin 30, qu'elles soient perpendiculaires ou parallèles au plan XY du substrat 10, doivent être gravées complétement. Ceci doit être effectué sans laisser de résidus 160 de couche diélectrique sur la BOX 20 et sans endommager les couches sous-jacente à la couche diélectrique gravée, typiquement sans endommager 180 le sommet 31 des Fin 30 ou sans endommager 190 la face supérieure de la BOX 20. Par ailleurs il est important d'obtenir une gravure parfaitement anisotrope dans les angles 170 sans formation de pieds, ceci afin de conserver des angles bien droits.

Pour répondre à ce besoin, la solution classique consiste à utiliser une gravure plasma pour graver la couche diélectrique. Si la gravure plasma a permis d'accompagner les réductions de taille des motifs jusqu'à présent, sa mise en oeuvre pose cependant de plus en plus de problèmes quand la taille diminue, en particulier à partir et au-delà du noeud technologique de 32 nm. Le caractère tridimensionnel (3D) de la structure FinFET fait que les problèmes déjà rencontrés avec une structure plane se posent avec encore plus d'acuité.

En particulier, il est particulièrement complexe de graver entièrement la couche diélectrique 40 sur le sommet 31 et les flancs 32 du Fin 30 sans pour autant endommager le Fin 30 ou laisser des résidus de couche diélectrique 40 tout en conservant des espaceurs 140 sur les flancs de la grille 130.

Le document US2017/0358502 décrit un procédé au cours duquel une couche diélectrique recouvrant le flanc d'un transistor est gravée.

Il existe donc un besoin consistant à proposer une solution pour graver entièrement et avec une grande précision une couche diélectrique située sur des faces d'une structure 3D tout en évitant d'endommager cette structure 3D.

Dans le cadre particulier et non limitatif des transistors de type FinFET, un objectif de la présente invention consiste à proposer une solution pour graver sur les Fins la couche diélectrique destinée à former des espaceurs sur les flancs de la grille, tout en évitant, voire en supprimant, les résidus de couche diélectrique de part et d'autre des Fins ainsi que la consommation de couches sous-jacentes à la couche diélectrique telle que la couche semi conductrice formant le Fin.

Par ailleurs, cette solution ne doit pas dégrader le contrôle dimensionnel des espaceurs situés sur les flancs de la grille.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation, la présente invention prévoit un procédé de gravure d'une couche diélectrique recouvrant au moins partiellement un flanc d'au moins une structure en un matériau semi-conducteur, les flancs s'étendant dans des plans perpendiculaires à un plan de base, la structure présentant au moins une face présentant, en projection sur le plan de base et selon une direction perpendiculaire au plan de base, une surface non nulle.

Le procédé comprend une pluralité de séquences comprenant chacune au moins les étapes successives suivantes :
∘une oxydation principale de manière à former un film d'oxyde, le film d'oxyde présentant au moins :
   - au moins une première portion formée à la surface de la couche diélectrique et s'étendant dans au moins un plan perpendiculaire au plan de base,
   - au moins une deuxième portion formée sur la couche diélectrique et présentant, en projection selon une direction perpendiculaire au plan de base, une surface non nulle,
   - au moins une troisième portion formée sur ladite face et présentant, en projection selon une direction perpendiculaire au plan de base, une surface non nulle, la composition de l'au moins une deuxième portion étant différente de la composition de l'au moins une troisième portion,
∘une gravure anisotrope principale du film d'oxyde, par plasma, la gravure anisotrope principale étant effectuée de manière à :
   - présenter une direction privilégiée qui soit perpendiculaire au plan de base,
   - graver ladite deuxième première portion et une partie au moins de la couche diélectrique située sous la deuxième portion, c'est-à-dire au droit de la deuxième portion selon l'axe Z,
   - être stoppée avant de graver :
      ∘ ladite structure en un matériau semiconducteur, et
      ∘ les portions de couche diélectrique sur lesquelles la première portion du film d'oxyde a été formée lors de l'étape d'oxydation principale.

L'invention est telle que définie dans les revendications.

La séquence est réitérée jusqu'au retrait complet de la couche diélectrique située sur les flancs de ladite structure en un matériau semiconducteur.

Ainsi, le procédé selon l'invention prévoit, avant chaque étape de gravure anisotrope principale, de former un film d'oxyde sur la surface des portions de la couche diélectrique recouvrant les flancs de la structure. Ce film d'oxyde s'étend sur toutes les parois perpendiculaires au plan de base. Ce film d'oxyde protège ainsi ces parois contre toute consommation latérale non souhaitée lors de la gravure de la couche diélectrique selon la direction privilégiée. En effet, dans le cadre du développement de la présente invention, il s'est avéré que lors d'une gravure, même très anisotrope, la couche diélectrique est consommée latéralement, c'est-à-dire selon une direction perpendiculaire à la direction privilégiée de la gravure.

Cette consommation latérale, même faible, peut présenter des inconvénients majeurs. En effet, dans certaines zones, il est indispensable de parfaitement contrôler l'épaisseur de la couche diélectrique. Tel est par exemple le cas sur les flancs des grilles des transistors. Une consommation, même faible d'une partie de l'épaisseur des espaceurs formés par cette couche diélectrique peut dégrader significativement les performances du transistor.

Le procédé selon l'invention permet de protéger ces espaceurs lors de la gravure anisotrope principale qui a pour objectif de consommer la couche diélectrique en dehors des zones d'intérêt.

Typiquement, dans le cas des transistors de type FinFET, et comme cela a été indiqué en introduction, il est nécessaire de retirer la couche diélectrique sur tous les flancs du Fin, tout en conservant la couche diélectrique sur les flancs de la grille.

Le procédé selon l'invention permet de consommer la couche diélectrique de manière parfaitement anisotrope, c'est-à-dire selon la direction privilégiée de gravure. Il est donc possible de retirer toute la hauteur de la couche diélectrique située sur les flancs du Fin, de retirer une hauteur correspondante de couche diélectrique située en regard du masque dur surmontant la grille, sans pour autant graver latéralement la portion de la couche diélectrique située sur les flancs de la grille.

Par ailleurs, à chacune des séquences, la gravure anisotrope principale est stoppée avant de graver la structure en matériau semi-conducteur.

En effet, les portions de film d'oxyde, formées à la surface de la couche diélectrique présentent une composition plus sensible à la gravure que les portions de film d'oxyde surmontant le substrat en matériau semi-conducteur. Ainsi, lors de la gravure anisotrope principale :
ole film d'oxyde formé à la surface de la couche diélectrique est gravé selon la direction privilégiée. Il ne protège alors plus la couche diélectrique sous-jacente qui est à son tour gravée.
∘le film d'oxyde surmontant le substrat en matériau semi-conducteur résiste à la gravure et agit comme une couche de protection pour empêcher la gravure du substrat en matériau semi-conducteur.

Ainsi, la présente invention propose une solution efficace pour graver entièrement et avec une grande précision la couche diélectrique sur le sommet et les faces d'une structure 3D tout en évitant d'endommager cette structure 3D.

Typiquement, la gravure est telle que l'on peut contrôler l'arrêt sur la couche de matériau semi-conducteur à une échelle atomique.

Le procédé proposé permet d'améliorer significativement les performances des transistors.

La solution proposée par la présente invention présente de nombreux avantages.

En particulier, dans le cadre du développement de la présente invention, il s'est avéré que les solutions classiques de gravure des espaceurs en nitrure de silicium (SiN) qui reposent sur l'utilisation de chimie fluorocarbonée (FC) induisent très souvent une consommation (habituellement qualifiée de « recess » en anglais) non souhaitée du silicium formant le Fin du transistor FinFET.

En effet il a été remarqué que la gravure fluorocarbonée de la couche diélectrique induit, en plus d'une consommation de silicium, une modification d'une portion superficielle de la couche de silicium. Cette portion superficielle se transforme en une couche de SiₓO_{y}F_{z} qui se trouve retirée durant la gravure ou après la gravure durant l'étape de nettoyage humide. Par ailleurs cette portion superficielle modifiée induit des défauts lors de la croissance épitaxiale.

Par ailleurs, pour réduire cette consommation excessive de silicium, il a été envisagé d'ajuster les conditions d'implantation des ions issus du plasma. Dans un plasma conventionnel, l'énergie minimale des ions est d'environ 20 eV. Avec ce niveau d'énergie, on observe des endommagements significatifs de la couche exposée au plasma. Une solution, éventuellement envisageable par un homme du métier afin de limiter ces endommagements, consisterait à réduire la température Te des électrons, ce qui conduirait à réduire le potentiel du plasma et à réduire par conséquent l'énergie des ions. Une autre solution, éventuellement envisageable par un homme du métier, consisterait à utiliser un plasma pulsé. Cependant, ces deux solutions ne sont pas satisfaisantes ou ne sont que partiellement satisfaisantes puisque :
∘une réduction de la température du plasma conduit à élargir l'angle de distribution des ions, réduisant ainsi le caractère anisotrope de la gravure et dégradant au final le contrôle dimensionnel du profil de la structure 3D,
∘l'utilisation d'un plasma pulsé ne permet pas d'éliminer complètement l'endommagement de la couche sous-jacente à la couche diélectrique que l'on souhaite graver.

Ainsi, au mieux, l'homme du métier aurait eu à sa disposition des solutions l'obligeant à effectuer un compromis entre endommagement de la couche sous-jacente et contrôle dimensionnel du profil.

Un autre aspect de la présente invention concerne un procédé de réalisation d'un transistor FinFET surmontant un substrat de support, le transistor FinFET comprenant une grille et au moins un canal traversant la grille. Le canal s'étend depuis un flanc de la grille pour former au moins une structure de préférence faite en un matériau semi-conducteur, ladite structure présentant un sommet et au moins deux flancs.

Le procédé comprend :
ole dépôt, de préférence conforme, d'une couche diélectrique recouvrant la grille et ladite structure,
ola gravure de la couche diélectrique en mettant en oeuvre le procédé selon l'un quelconque des modes de réalisation du procédé de gravure selon l'invention, de manière à retirer complètement la couche diélectrique située sur la structure formée par le canal.

De manière facultative, le procédé de réalisation d'un transistor FinFET peut comprendre au moins l'une quelconque des caractéristiques suivantes prises isolément ou en combinaison :
Selon un exemple de réalisation, le transistor présente un masque dur recouvrant un sommet de la grille, la couche diélectrique étant déposée sur le masque dur, le masque dur présentant une épaisseur e₁₅₀, tel que e₁₅₀ ≥ e₃₀, e₃₀ étant l'épaisseur de ladite structure, et de préférence e₁₅₀ ≥ 1.2 x e₃₀.

Ainsi, lorsque la gravure consomme entièrement la couche diélectrique située sur les flancs de la structure, toute la hauteur des flancs de la grille reste recouverte par la couche diélectrique. Par conséquent, le retrait de la couche diélectrique sur les flancs du Fin n'entraîne pas de retrait de cette couche diélectrique sur les flancs de la grille. Ces derniers restent donc efficacement protégés par les espaceurs.

Les épaisseurs du masque dur et de la structure sont prises selon des directions perpendiculaires (Z) au plan principal (XY) dans lequel s'étend le substrat de support.

Un autre objet de la présente invention concerne un dispositif microélectronique comprenant une pluralité de transistors FinFET selon l'invention. Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 illustre de manière schématique un transistor de type FinFET.
La FIGURE 2 illustre de manière schématique un transistor de type FinFET en cours de réalisation, une couche diélectrique conforme étant déposée sur toutes les surfaces du transistor.
La FIGURE 3, composée des FIGURES 3A à 3G, illustre de manière schématique des étapes d'un procédé selon un premier mode de réalisation non limitatif de la présente invention.
La FIGURE 4, est un ordinogramme illustrant certaines des étapes du procédé illustré en FIGURE 3.
La FIGURE 5, composée des FIGURES 5A à 5I, illustre de manière schématique des étapes d'un procédé selon un deuxième mode de réalisation non limitatif de la présente invention.
La FIGURE 6, est un ordinogramme illustrant certaines des étapes du procédé illustré en FIGURE 5.
La FIGURE 7, comprend les FIGURES 7A et 7B qui comportent chacune des graphes illustrant la consommation de la couche diélectrique et la consommation de la couche de semi-conducteur en fonction de la présence de CH2F2 (pour la figure 7A) et de O2 (pour la figure 7B) dans le plasma.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches, couche d'oxyde de protection et films d'oxyde ne sont pas représentatives de la réalité.

En particulier, l'épaisseur du film d'oxyde est volontairement exagérée.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la gravure anisotrope principale du film d'oxyde, par plasma, utilise une chimie fluorocarbonée.

Selon un exemple, ladite structure forme au moins un Fin d'un transistor de type FinFET.

Selon un exemple, la deuxième portion s'étend selon au moins un plan non perpendiculaire au plan de base (XY).

Selon un exemple, la troisième portion s'étend selon au moins un plan non perpendiculaire au plan de base (XY).

Selon un exemple, ladite structure est surmontée d'un motif de grille présentant des flancs recouverts par la couche diélectrique, le motif de grille étant surmonté d'un masque dur dont la hauteur est supérieure ou égale à la hauteur de ladite structure, les hauteurs et étant prises selon ladite direction privilégiée (Z).

Selon un exemple, l'oxydation principale est effectuée dans un réacteur de gravure plasma et ladite gravure anisotrope principale est effectuée dans le même réacteur de gravure plasma.

Cela permet de considérablement de simplifier et raccourcir les cycles de fabrication. Il en résulte un coût de fabrication réduit.

Selon un exemple de réalisation, le dépôt de ladite couche diélectrique est un dépôt conforme.

Selon un mode de réalisation, la gravure principale anisotrope est stoppée avant de consommer toute l'épaisseur de la première portion du film d'oxyde et nitrure, ladite épaisseur étant mesurée selon une direction parallèle au plan de base ou tout au moins avant de graver, selon une direction parallèle au plan de base, la couche diélectrique s'étendant selon des plans perpendiculaires au plan de base. Ainsi on conserve le contrôle dimensionnel des portions de couche diélectrique destinées à former les espaceurs de grille.

La gravure principale anisotrope est contrôlée au temps.

Selon un exemple, préalablement à ladite pluralité de séquences, le procédé comprend :
∘une étape de dépôt de la couche diélectrique de sorte à ce que la couche diélectrique recouvre les flancs et la face de ladite structure,
∘une étape de gravure initiale, réalisée de manière anisotrope selon ladite direction privilégiée de sorte à retirer une portion au moins de la couche diélectrique située sur une portion moins de la face de ladite structure, la gravure initiale étant stoppée avant de consommer la face de la structure.

Selon un exemple, après l'étape de dépôt de la couche diélectrique et avant l'étape de gravure initiale, le procédé comprend une étape d'oxydation initiale, effectuée de sorte à former un film d'oxyde initial sur toute la surface de la couche diélectrique.

Avantageusement, ce film d'oxyde initial permet de limiter la consommation latérale de la couche diélectrique lors de l'étape de gravure initiale. Ainsi, lors de l'étape de gravure initiale on conserve le contrôle dimensionnel de la couche diélectrique située sur les flancs.

Selon un exemple, l'étape de gravure initiale est stoppée avant de consommer toute l'épaisseur de portions du film d'oxyde initial situées sur des surfaces de la couche diélectrique s'étendant dans des plans perpendiculaires (YZ, ZX) au plan de base (XY).

Ainsi, la gravure initiale est stoppée :
∘soit avant de graver la structure semi conductrice telle qu'un Fin de transistors FinFET,
∘soit avant de graver latéralement la couche diélectrique, dont certaines portions sont par exemple destinées à former les espaceurs de grille.

Selon un exemple, l'étape de gravure initiale est une gravure plasma basée sur une chimie fluorocarbonée, et de préférence une chimie à base de CₓH_{y}F_{z} diluée avec l'une ou plusieurs parmi les espèces suivantes : l'argon, hélium, l'azote, l'oxygène.

Selon un mode de réalisation, préalablement à ladite pluralité de séquences, la couche diélectrique recouvre les flancs de ladite structure, au moins une portion de la face de ladite structure n'étant pas recouverte par la couche diélectrique.

Selon un exemple, lors de ladite étape d'oxydation principale, l'au moins une troisième portion du film d'oxyde est formée par oxydation de ladite face de la structure, la composition de la deuxième portion du film d'oxyde étant différente de la composition de la troisième portion du film d'oxyde et ladite gravure anisotrope principale étant configurée de manière à graver plus rapidement la deuxième portion du film d'oxyde que la troisième portion du film d'oxyde.

Selon un exemple, la composition de la deuxième portion du film d'oxyde, à l'issue de l'étape d'oxydation principale, et avant l'étape de gravure anisotrope principale, est du SiₓO_{y}N_{z}Fₜ et la composition de la troisième portion du film d'oxyde est du SiₓO_{y}F_{z}, x, y, z et t étant des entiers des entiers non nuls.

Selon un mode de réalisation, la couche diélectrique est formée en SiₓN_{y}, x et y étant des entiers non nuls. Typiquement, elle est formée de Si₃N₄.

Selon un exemple, la gravure anisotrope principale du film d'oxyde est effectuée de manière à s'arrêter avant de graver toute l'épaisseur de ladite troisième portion du film d'oxyde.

Selon un exemple, l'oxydation principale est effectuée dans un réacteur de gravure plasma, en utilisant une tension de polarisation inférieure ou égale à 50 Volts, de préférence inférieure à 30 Volts.

Cette tension de polarisation permet d'éviter de soumettre ladite structure à un bombardement trop important, ce qui est particulièrement avantageux lorsque ladite structure est à base de silicium.

De préférence, toutes les étapes de ce mode de réalisation sont réalisées dans le même réacteur.

Ce mode de réalisation permet, avec un nombre d'étapes réduit et une grande fiabilité, de graver de manière très anisotrope et avec une grande précision la couche diélectrique sur le sommet et les faces d'une structure 3D tout en évitant d'endommager cette structure 3D et sans attaquer latéralement la couche diélectrique s'étendant dans des plans parallèles à la direction privilégiée de la gravure anisotrope. Typiquement, la gravure est telle que l'on peut contrôler l'arrêt sur la couche de silicium à une échelle atomique.

Selon un autre mode de réalisation, chaque séquence comprend, avant ladite oxydation principale :
une gravure préalable de la couche diélectrique (40), anisotrope, par plasma, en utilisant une chimie comprenant au moins:
   - au moins une chimie fluorocarbonée comprenant un premier composé, le premier composé étant à base de fluor (F) et
   - au moins un deuxième composé pris parmi le Si_{w}Cl_{(2w+2)} et le Si_{w}F_{(2w+2)} w, x, y et z étant des entiers non nuls,
   - de l'oxygène (O),
   la gravure préalable étant effectuée de manière à :
   - générer un bombardement ionique dirigé principalement selon ladite direction privilégiée (Z),
   - réguler la quantité de l'au moins un premier composé pour consommer tout le composé à base de fluor lors de cette première gravure de manière à interrompre la première gravure après avoir consommé une partie au moins de la couche diélectrique située sur les flancs de la structure,
   - déposer une première couche d'oxyde de protection, d'épaisseur e60, à la surface de portions de la couche diélectrique présentant, en projection sur le plan de base (XY), une surface non nulle,
   - déposer une deuxième couche d'oxyde de protection, d'épaisseur e70, à la surface de ladite face, l'épaisseur e70 étant supérieure à l'épaisseur e60, du fait d'une différence de composition de la première couche d'oxyde de protection et de la deuxième couche d'oxyde de protection,
ladite gravure anisotrope principale étant effectuée de sorte à :
   - graver entièrement la première couche d'oxyde de protection,
   - être stoppée avant de graver entièrement toute l'épaisseur e70a de la deuxième couche d'oxyde de protection, ou tout au moins avant de graver ladite structure en un matériau semiconducteur située sous la deuxième couche d'oxyde de protection.

Ainsi, à chaque séquence, la gravure anisotrope principale est effectuée de sorte à :
∘graver :
   - ladite deuxième première portion du film d'oxyde, et
   - graver entièrement la première couche d'oxyde de protection,

Cela permet d'atteindre les portions de la couche diélectrique située sous la deuxième portion et de graver une partie au moins de la couche diélectrique située sur les flancs;
∘être stoppée avant de graver :
   - entièrement la deuxième couche d'oxyde de protection, ou tout au moins avant de graver ladite structure en un matériau semiconducteur située sous, c'est-à-dire au droit de (selon la direction privilégiée), la deuxième couche d'oxyde de protection, cela permet d'empêcher toute consommation involontaire de ladite structure en un matériau semiconducteur.
   - toute l'épaisseur de la première portion du film d'oxyde, ladite épaisseur étant mesurée selon une direction parallèle au plan de base (XY),

Cela permet d'éviter de consommer latéralement la couche diélectrique recouvrant les flancs.

Ainsi, la présente invention propose une solution efficace pour graver de manière très anisotrope et avec une grande précision la couche diélectrique sur le sommet et les faces d'une structure 3D tout en évitant d'endommager cette structure 3D et sans attaquer latéralement la couche diélectrique s'étendant dans des plans parallèles à la direction privilégiée de la gravure anisotrope.

Typiquement, la gravure est telle que l'on peut contrôler l'arrêt sur la couche de silicium à une échelle atomique.

En effet, la chimie utilisée lors de la gravure préalable, combinant espèces fluorées et au moins un gaz à base de silicium permet de graver efficacement la couche diélectrique, avec une forte sélectivité par rapport au matériau semi-conducteur de la structure 3D. Par ailleurs, cette gravure préalable s'interrompt, lorsque toute l'espèce fluorée est consommée, avant gravure du matériau semi-conducteur de la structure 3D. La présence d'oxygène dans le plasma conduit à la formation d'une couche d'oxyde de protection dont l'épaisseur est plus importante sur le matériau semi-conducteur de la structure que sur la couche diélectrique.

La gravure anisotrope principale, qui intervient après la gravure préalable, permet de retirer la couche d'oxyde de protection sur la couche diélectrique, tout en conservant cette couche d'oxyde de protection sur le matériau semi-conducteur. Lors de la gravure préalable de la séquence suivante, le matériau semi-conducteur sera donc protégé par le résidu de la couche d'oxyde de protection ce qui limitera la gravure de ce dernier, alors que la couche diélectrique ne sera plus protégée par la couche d'oxyde de protection. La couche diélectrique, mise à nu, se gravera donc aisément.

En répétant cette séquence d'étapes, on grave ainsi rapidement la couche diélectrique tout en consommant extrêmement peu, voire sans consommer le matériau semi-conducteur de la structure 3D.

Par ailleurs, le film d'oxyde formé à la surface de la couche diélectrique recouvrant les flancs empêche toute consommation latérale de cette dernière. La couche diélectrique recouvrant des surfaces perpendiculaires au plan de base XY est donc gravé de manière parfaitement anisotrope, c'est-à-dire uniquement selon la direction privilégiée Z. Le contrôle dimensionnel de l'épaisseur de la couche diélectrique est donc considérablement amélioré.

Lorsque la structure 3D est destinée à former un transistor de type FinFET, la présente invention propose ainsi une solution efficace pour graver la couche diélectrique déposée sur les Fins, tout en évitant, voire en supprimant, les résidus de couche diélectrique en dehors des Fins ainsi que la consommation de couches sous-jacentes à la couche diélectrique telle que la couche semi conductrice formant le Fin.

Par ailleurs, le film d'oxyde formé à la surface de la couche diélectrique permet en outre de préserver le contrôle dimensionnel des espaceurs recouvrant les flancs de la grille.

Selon un exemple, ledit premier composé à base de fluor (F) de la chimie utilisée pour l'étape de gravure préalable provient, de préférence intégralement, de la chimie utilisée lors de ladite étape de gravure initiale.

Selon un exemple, l'étape de gravure initiale est interrompue de manière à conserver une portion de la couche diélectrique située sur ladite face de la structure en un matériau semi-conducteur, l'étape de gravure initiale étant basée sur une chimie fluorocarbonée.

Selon un exemple, la gravure anisotrope principale est une gravure à base d'une chimie fluorocarbonée.

Avant l'oxydation principale, et de préférence après l'oxydation préalable lorsque cette dernière est effectuée, la couche diélectrique recouvre les flancs de ladite structure et au moins une portion de la face de ladite structure n'est pas recouverte par la couche diélectrique. De préférence cette portion est découverte. Elle est ainsi accessible pour être oxydée lors de l'oxydation principale.

Selon un mode de réalisation, la couche diélectrique est formée dans l'un des matériaux suivants : SiCO, SiC, SiCN, SiOCN ou SiCBN, ou un nitrure de silicium (SixNy, x et y étant des entiers non nuls). Typiquement elle est formée de Si₃N₄. Elle peut encore s'agir de tout autre matériau dit low-k (c'est-à-dire à faible constante diélectrique), dont la constante diélectrique est inférieure à 7.

De préférence, toutes les étapes de ce mode de réalisation sont réalisées dans le même réacteur.

Ce mode de réalisation dans lequel chaque séquence inclut une gravure préalable, peut comprendre au moins l'une quelconque des caractéristiques et étapes mentionnées ci-dessous, prises séparément ou en combinaison :
De préférence, le dépôt de ladite couche diélectrique est un dépôt conforme.

Selon un exemple de réalisation, le procédé comprend l'étape de gravure initiale, réalisée avant les dites séquence d'étapes. Cette étape de gravure initiale est interrompue de manière à conserver une portion de la couche diélectrique située sur le sommet de la structure en un matériau semi-conducteur.

Selon un exemple de réalisation, l'étape de gravure initiale de la couche diélectrique est basée sur une chimie fluorocarbonée (par exemple CₓF_{y} ou CₓH_{y}F_{z}).

Selon un exemple de réalisation, l'étape de gravure initiale est interrompue en contrôlant le temps de gravure, de manière à ce l'épaisseur e₁₁ gravée de la couche diélectrique lors de cette étape de gravure initiale est telle que 0.7 x e₁₀ ≥ e₁₁ ≥ 0.95 x e₁₀, e₁₀ étant l'épaisseur de la couche diélectrique avant gravure par ladite étape de gravure initiale.

Ainsi, cette étape de gravure initiale permet de graver une portion importante de la couche diélectrique. Elle permet d'augmenter la rapidité du procédé.

Selon un exemple de réalisation, e₁₀ ≥ 6 nm et de préférence e₁₀ ≥ 8 nm.

Selon un exemple de réalisation, ladite portion de la couche diélectrique conservée à l'issue de l'étape de gravure initiale présente une épaisseur e₁₂ supérieure ou égale à 2 nm (2.10⁻⁹ mètres) et de préférence comprise entre 2 et 5 nm, avec e₁₂=e₁₀-e₁₁.

Cette étape permet ainsi de retirer une partie de l'épaisseur de la couche diélectrique tout en s'assurant que la structure en un matériau semi-conducteur n'est pas gravée ou altérée.

Selon un exemple de réalisation, ledit premier composé à base de fluor (F) de la chimie utilisée pour l'étape de gravure préalable provient, de préférence intégralement, de la chimie utilisée lors de ladite étape préalable de gravure.

Alternativement, une partie au moins et optionnellement tout le premier composé à base de fluor (F) de la chimie utilisée pour l'étape de gravure préalable est fourni durant l'étape de gravure préalable.

Selon un exemple de réalisation, le premier composé à base de fluor (F) provient de la dissociation d'au moins un composé pris parmi les composés fluorocarbonés (par exemple CₓF_{z} ou CₓH_{y}F_{z}).

Selon un exemple de réalisation, la gravure anisotrope principale est une gravure à base d'une chimie fluorée ou fluorocarbonée (par exemple CₓF_{z} ou CₓH_{y}F_{z}).

Selon un exemple de réalisation, la gravure anisotrope principale est contrôlée au temps, de manière à retirer entièrement la première couche d'oxyde de protection et à conserver une partie e_{70b} de l'épaisseur e₇₀ₐ de la deuxième couche d'oxyde de protection.

Ainsi lors d'une gravure ultérieure, le sommet du substrat reste protégé par la deuxième couche d'oxyde de protection alors que le sommet de la couche de nitrure située sur le flanc est quant à elle non protégée. Cette dernière pourra ainsi être aisément gravée selon la direction privilégiée.

Chacun des modes de réalisation proposés ci-dessus peuvent également comprendre au moins l'une quelconque des caractéristiques et étapes mentionnées ci-dessous, prises séparément ou en combinaison :
Selon un exemple de réalisation, ladite structure est tridimensionnelle (3D).

Selon un exemple de réalisation, la structure en un matériau semi-conducteur est faite en un matériau pris parmi les matériaux suivants: silicium (Si), germanium (Ge), silicium-germanium (SiGe).

La structure en un matériau semi-conducteur peut également être formée d'une succession de couche semi conductrice. Elle peut par exemple être formée d'une succession de couches de Si et de SiGe. Elle peut par exemple être le cas dans le cadre de la réalisation de nanofils.

Selon un mode de réalisation, la structure surmonte un substrat qui s'étend parallèlement au plan de base.

Selon un exemple de réalisation, la structure en un matériau semi-conducteur forme un canal d'un transistor FinFET.

Selon un mode de réalisation, la face forme un sommet pour des Fins d'un transistor de type FinFET.

Selon un mode de réalisation, ladite face est plane et s'étend parallèlement au plan de base.

Selon un exemple de réalisation, ladite structure est formée par au moins un bloc ou une lamelle de matériau semi-conducteur. Alternativement, ladite structure est formée par une couche, éventuellement conforme, présentant une forme tridimensionnelle.

Selon un exemple de réalisation, le sommet s'étend principalement dans un plan parallèle au plan (XY) du substrat de support.

Selon un exemple de réalisation, ladite structure comprend des premières surfaces qui sont perpendiculaires au plan de substrat de support et des deuxièmes surfaces qui sont non perpendiculaires audit plan de substrat de support.

Selon un exemple de réalisation, les flancs de la structure sont perpendiculaires au plan XY dans lequel s'étend principalement le substrat de support. Alternativement, les flancs de la structure sont inclinés par rapport à une direction Z perpendiculaire au plan XY dans lequel s'étend principalement le substrat de support.

Selon un exemple de réalisation, la couche diélectrique est directement au contact de la structure en un matériau semi-conducteur.

Selon un exemple de réalisation, lorsque la couche diélectrique située sur le flanc de la structure est entièrement gravée, on effectue ensuite une étape de retrait de la deuxième couche d'oxyde de protection.

Dans le cadre de la présente invention, lorsque l'on indique que la gravure d'une couche A est stoppée avant de consommer ou de graver une couche B située sous la couche A, cela signifie que le couche B n'est pas du tout consommée ou que, du fait des inévitables imprécisions des procédés, la couche B est involontairement consommée sur une épaisseur très faible, typiquement une épaisseur inférieure à 1,5 nm et de préférence une épaisseur inférieure à 1 nm et de préférence une épaisseur n'excédant pas plus de trois couches atomiques de la couche B. Ces épaisseurs sont mesurées selon la direction privilégiées de la gravure anisotrope de la couche A.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un film, une couche, « à base » d'un matériau A, un substrat, un film, une couche comprenant ce matériau A uniquement ou ce matériau A et éventuellement d'autres matériaux, par exemple des éléments dopants.

Dans le cadre de la présente invention, une chimie fluorocarbonée est une chimie comprenant du fluor (F) et du carbone (C). Sa composition est par exemple l'une des compositions suivantes : CₓF_{z}, CₓH_{y}F_{z} etc.

Le mot « diélectrique » qualifie un matériau dont la conductivité électrique est suffisamment faible dans l'application donnée pour servir d'isolant.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « nature » d'un matériau, sa composition chimique et/ou sa structure cristalline. Ainsi deux couches peuvent être de même composition chimique mais de nature différente d'un point de vue cristallographique.

Il est précisé que dans le cadre de la présente invention, l'épaisseur d'une couche ou du substrat se mesure selon une direction perpendiculaire à la surface selon laquelle cette couche ou ce substrat présente son extension maximale.

Sauf indication contraire, sur les figures, l'épaisseur est prise selon la verticale, c'est dire selon l'axe Z.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures

Dans le cadre de la présente invention, on désigne par structure en trois dimensions une structure formant une saillie au-dessus d'une couche qui lui est sous-jacente telle un substrat de support ou une structure présentant un profil présentant au moins deux niveaux discrets de hauteur ou qui présentent un profil analogique avec une variation continue des tangentes de la forme du profil.

Dans le cadre de la présente, un exemple non limitatif mais particulièrement avantageux de structure 3D est une lamelle (également désignée nageoire ou par son vocable anglais Fin) formant l'extension d'un canal de transistor FinFET.

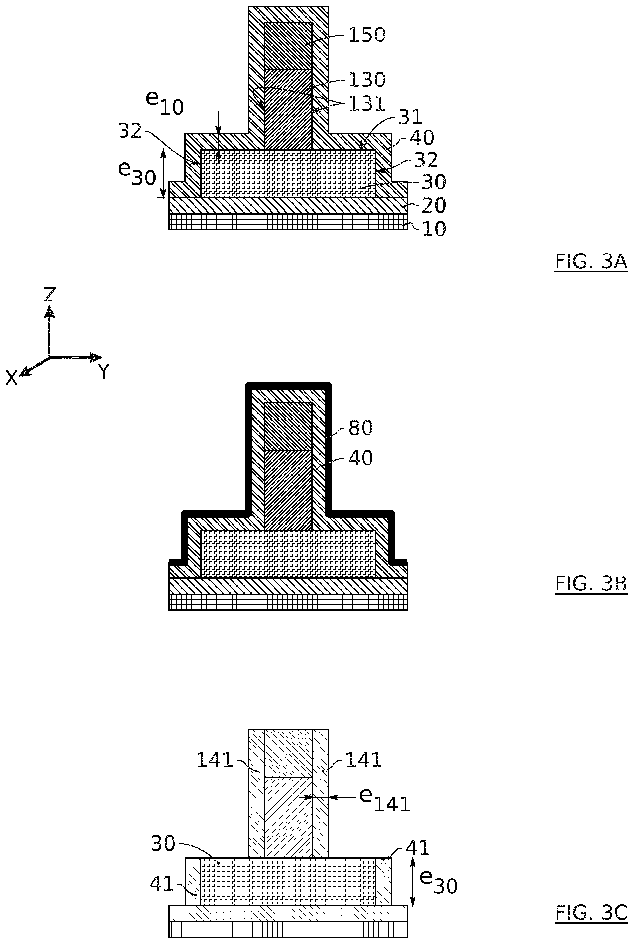

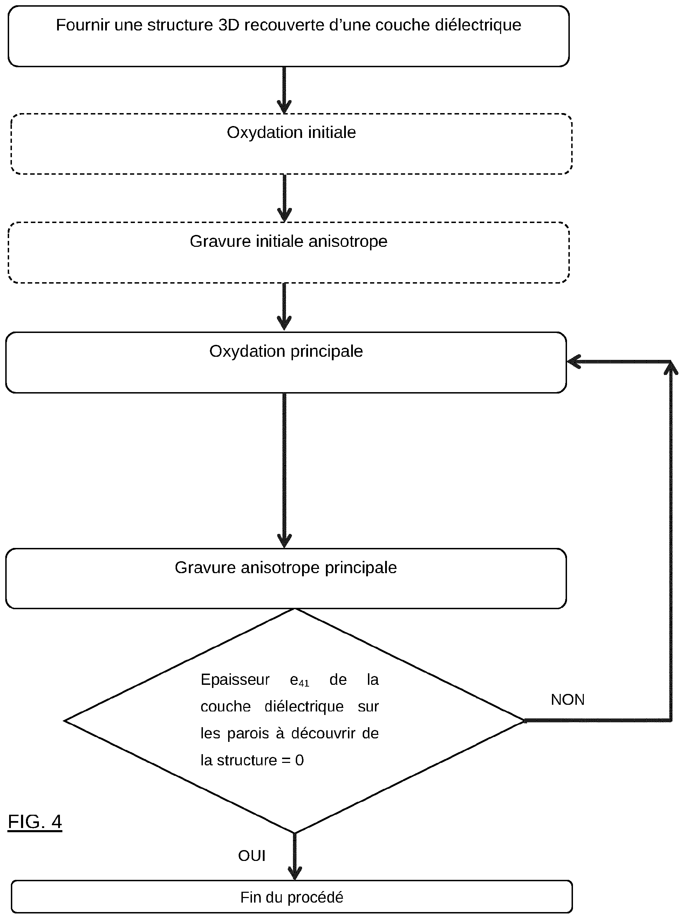

En référence aux figures 3A à 3G et à la figure 4, un exemple non limitatif de l'invention va maintenant être décrit.

Sur ces figures, la couche diélectrique 40 que l'on souhaite graver surmonte une structure tridimensionnelle formée par le Fin 30 d'un transistor FinFET 100. Toutes les caractéristiques, étape et avantages techniques qui vont être décrits par la suite s'appliquent également à des modes de réalisation dans lesquels la couche diélectrique 40 surmonte une structure 30 différente d'un Fin d'un transistor FinFET 100.

La figure 3A illustre un transistor FinFET 100 en cours de réalisation. Cette structure comprend un substrat de support 10, surmonté d'une couche isolante 20, typiquement une couche d'oxyde enterré BOX et d'une fine couche semi conductrice. Cet ensemble forme de préférence un substrat élaboré, de préférence de type semi-conducteur sur isolant.

Selon un autre mode de réalisation couvert par la présente invention, les transistors FinFET sont fabriqués sur des substrats massifs. Dans ce cas, le Fin 30 s'étend verticalement (selon l'axe Z) jusqu'au substrat massif, typiquement du silicium. Le motif de grille repose quant à lui sur une couche diélectrique.

La structure 30 comprend également un motif qui s'étend depuis la structure 30. Selon un exemple non limitatif, ce motif est un motif de grille 130. Selon un mode de réalisation il peut s'agir d'un empilement de grille, qui sera désigné ci-dessous par le terme grille pour des raisons de concision. Ce motif de grille 130 comprend notamment une portion habituellement en silicium dopé ou en métal, une couche métallique et une couche isolante électriquement dite oxyde de grille située entre la couche active et la grille en silicium polycristallin. L'empilement de grille peut également comprendre une couche diélectrique dite « high-k », c'est-à-dire faite d'un matériau à haute permittivité. Lorsqu'elle est présente, cette couche diélectrique est située entre l'oxyde de grille et la grille métallique. Pour des raisons de clarté, sur la figure 3A un seul bloc représente l'ensemble de cet empilement formant la grille 130. Un masque dur 150 surmonte la grille 130. Le masque dur 150 peut être formé d'une couche unique ou d'un empilement de différents matériaux. La grille 130 s'étend principalement dans le plan ZX du repère orthogonal XYZ référencé en figure 3A.

Un motif traverse la grille 130 de part en part, selon l'axe Y. Ce motif présente généralement une forme de nageoire. Il est désigné Fin 30. Il forme le canal du transistor ainsi que des extensions, situées de part et d'autre de la grille 130, et qui sont destinées à former des zones de source et drain. Ce motif présente des flancs 32 et une face supérieure 31 également désignée sommet 31. Les flancs 32 s'étendent de préférence dans un plan YZ perpendiculaire au plan XY dans lequel s'étend principalement le substrat de support 10. Sur cet exemple, et sans que cela soit limitatif, la face supérieure 31 s'étend dans un plan parallèle au plan XY. Ainsi, le motif semi-conducteur forme une structure 30 tridimensionnelle. Elle forme une saillie sur la face supérieure de l'empilement de couches comprenant le substrat de support 10 et la couche isolante 20.

Dans cet exemple, la structure 30 est faite en un matériau semi-conducteur, typiquement pris parmi le silicium, le silicium germanium et le germanium. Cette structure peut également être formée par un empilement de couche semi conductrice, par exemple une alternance de couches de Si e de SiGe.

Sur les figures, la grille, le canal et les Fin sont illustrés par un matériau homogène. Néanmoins, l'invention couvre également le cas où l'un ou plusieurs de ces éléments sont formés d'un empilement de couches tels qu'un empilement de nanofils, formant par exemple une alternance Si/SiGe.

La figure 3A est une vue en coupe selon un plan parallèle au plan ZX est pris au niveau d'un Fin 30.

La hauteur e₃₀ du Fin 30 est référencée sur cette figure 3A. Par exemple, la hauteur e₃₀ du Fin, mesurée selon la direction Z, est comprise entre quelques nanomètres et quelques dizaines de nanomètres. Préférentiellement, e₃₀ est comprise entre 10 et 200 nanomètres et encore plus préférentiellement, e₃₀ est compris entre 30 de 150 nm.

Comme illustré en figures 3A, une couche diélectrique 40 recouvre l'ensemble du transistor en cours de réalisation. De préférence, cette couche diélectrique 40 est une couche conforme.

Dans cet exemple lié aux transistors FinFET, cette couche diélectrique 40 est destinée à former des espaceurs 140 sur les flancs de la grille 130. Cette couche diélectrique 40 est alors formée dans des matériaux présentant une faible constante diélectrique. Cette couche diélectrique 40 peut être poreuse ou non.

Dans le mode de réalisation illustré en référence aux figures 3A à 3G, la couche diélectrique 40 est SiₓN_{y}, x et y étant des entiers non nuls, typiquement du SiN ou du Si₃N₄.

Une fois déposée, cette couche diélectrique 40 présente par exemple une épaisseur e₁₀ comprises entre 4 et 50 nanomètres de préférence, entre 4 et 30 nanomètres et de préférence entre 8 et 12 nanomètres. L'épaisseur e₁₀ est mesurée selon la direction Z. Elle est référencée en figure 3A.

Cette couche diélectrique 40 est par exemple formée par l'une des techniques suivantes: dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt par couche atomique assistée par plasma (PEALD, acronyme de plasma enhanced atomic layer déposition).

À partir de la structure illustrée en figure 3A plusieurs étapes vont être mises en oeuvre dans le but de retirer entièrement la couche diélectrique 40 sur la face supérieure 31 et sur les flancs 32 de la structure 30 formant le Fin, ainsi que de part et d'autre des flancs 32 du Fin 30, ceci, :
∘sans laisser de résidus de couche diélectrique sur le Fin 30,
∘sans endommager les couches sous-jacentes que sont le Fin 30 et la couche isolante 20,
∘sans consommer latéralement la couche diélectrique 40 recouvrant les flancs 131 de la grille 130.

La figure 3B illustre une première étape. Cette étape est optionnelle mais avantageuse. En effet, elle permet de contrôler le dimensionnel de l'espaceur depuis le début du procédé.

Au cours de cette étape on réalise une oxydation de toute la couche diélectrique 40 de sorte à former, un film d'oxyde désigné film d'oxyde initial 80. Pour des raisons de clarté, ce film d'oxyde initial est représenté de manière exagérément épais en figure 3B.

La composition de ce film d'oxyde initial 80 est typiquement à base de ou est du SixOyNz, x, y, z étant des entiers non nuls. Comme cela sera indiqué par la suite, ce film d'oxyde initial 80 présente pour intérêt de former un film protecteur pour limiter la consommation latérale de la couche diélectrique 40 lors de l'étape de gravure anisotrope subséquente.

Cette étape d'oxydation initiale est de préférence effectuée dans un équipement de gravure telle qu'un réacteur de gravure plasma. De préférence le réacteur est un réacteur plasma à couplage inductif (ICP). Il peut également s'agir d'un réacteur à couplage capacitif (CCP). Le plasma est formé à partir d'une chimie à base d'oxygène.

La figure 3C illustre une étape de gravure initiale de la couche diélectrique 40. Cette gravure est anisotrope et présente une direction privilégiée selon l'axe Z perpendiculaire au plan de base XY dans lequel s'étend la structure 30 et plus généralement le transistor. Cette gravure anisotrope, désignée par la suite gravure initiale, est réalisée de sorte à :
retirer, de préférence entièrement, la couche diélectrique 40 surmontant la structure 30 formant le Fin,
conserver la couche diélectrique 40 située sur les flancs 32 de la structure 30 est sur les flancs 131 de la grille 130.

Lors de cette étape, il est illusoire d'empêcher une consommation latérale, même faible des couches en présence. Ainsi, le film d'oxyde initial 80 est inévitablement consommé lors de cette étape de gravure initiale. Néanmoins, la chimie utilisée pour graver la couche diélectrique 40, grave plus rapidement cette dernière que le film d'oxyde initial 80.

Ainsi, le film d'oxyde initial 80 joue alors parfaitement son rôle de film protecteur afin d'empêcher la consommation latérale (c'est-à-dire selon une direction perpendiculaire la direction privilégiée Z) des portions 41, 141 de couche diélectrique 40 situées sur les parois perpendiculaires, c'est-à-dire sur les flancs 32, 131 de la structure 30 et de la grille 130.

Ainsi, lors de l'étape de gravure initiale on conserve le contrôle dimensionnel de la couche diélectrique 40 située sur les flancs 131 de la grille 130.

Naturellement, on adaptera les paramètres de l'oxydation initiale, en particulier l'épaisseur du film d'oxyde initial 80 ainsi que le temps de la gravure initiale de sorte à retirer entièrement la couche diélectrique 40 située sur le sommet de la structure 30 sans commencer à consommer latéralement les portions 141 de couche diélectrique 40 situées sur les flancs 131 de la grille 130.

Néanmoins, on peut prévoir qu'à l'issue de l'étape de gravure initiale, et comme cela est illustré en figure 3C, toute l'épaisseur du film d'oxyde initial 80 soit consommée.

Le procédé permettant de retirer la couche diélectrique 40 de manière anisotrope sur les flancs 32, 131 des parois verticales sans consommer cette couche latéralement comprend une séquence d'étapes, cette séquence étant réitérée jusqu'au retrait de toute la hauteur souhaitée de la couche diélectrique.

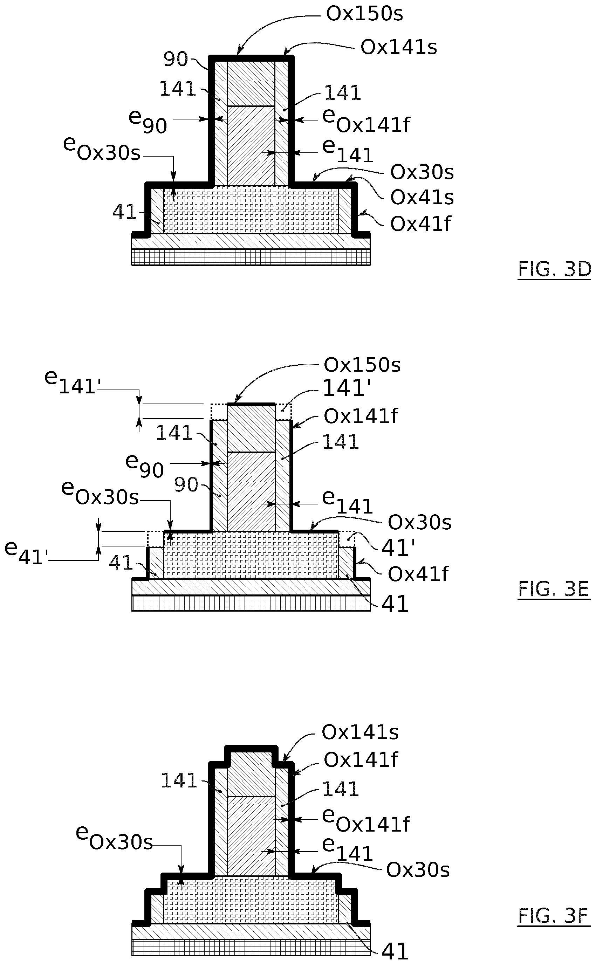

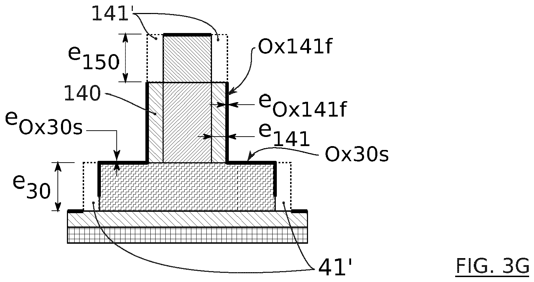

Une première séquence d'étapes est illustrée en référence aux figures 3D et 3E. Cette séquence peut être réitérée jusqu'à obtenir le résultat qui est illustré en figure 3G.

La figure 3D illustre une étape d'oxydation, désignée par la suite oxydation principale. Ce film d'oxyde 90 recouvre toute la surface découverte. Il est formé par oxydation des surfaces découvertes. Ce film d'oxyde 90 présente donc des compositions différentes en fonction de la nature des surfaces oxydées. Sur les figures, pour faciliter la compréhension de l'invention, le film d'oxyde 90 est représenté de manière exagérément épais.

Ainsi, ce film d'oxyde 90 présente :
oau moins une première portion Ox41f, Ox141f formée à la surface de la couche diélectrique 40 et s'étendant dans un plan perpendiculaire YZ, ZX au plan de base XY. Typiquement, les premières portions Ox41f, Ox141f sont formées par oxydation de la couche diélectrique recouvrant les flancs 32,131 de la structure 30 et de la grille 130.
oau moins des deuxièmes portions Ox41s, Ox141s, également formée sur la couche diélectrique 40. Ces deuxièmes portions présentent, en projection sur le plan de base XY, c'est-à-dire en projection orthogonale, donc selon une direction perpendiculaire Z, sur le plan de base XY, une surface non nulle. Typiquement, les deuxièmes portions Ox41s, Ox141s sont formées par oxydation de l'épaisseur de la couche diélectrique 40 recouvrant les parois perpendiculaires au plan de base XY.
oau moins une troisième portion Ox30s formée sur ladite face 31 et présentant, en projection selon une direction perpendiculaire Z au plan de base (XY), une surface non nulle. Typiquement, l'au moins une troisième portion Ox30s est formée par oxydation de la surface découverte de la structure 30 en matériau semi-conducteur.

Comme cela ressort des paragraphes qui précèdent, une projection selon une direction perpendiculaire Z au plan de base XY, correspond à une projection sur le plan de base XY selon la direction perpendiculaire Z. Il s'agit ainsi d'une projection orthogonale sur ce plan. La projection, sur le plan de base XY, d'une face perpendiculaire au plan XY, correspond à une ligne ou une courbe. Sa surface est nulle. Au contraire, si la projection sur le plan de base XY d'une face, présente une surface non nulle, alors cette face n'est pas perpendiculaire au plan de base XY. Cette face est alors inclinée par rapport à une direction Z perpendiculaire au plan de base XY. Cette face est par exemple parallèle au plan de base XY.

On notera également que le film d'oxyde 90 peut présenter une portion Ox150s formée par oxydation du masque dur 150 recouvrant la grille 130.

La composition des deuxièmes portions Ox41s, Ox141s est différente de la composition des troisièmes portions Ox30s.

Typiquement, si la couche diélectrique 40 est en SiₓN_{y} et la structure 30 à base de Si, alors le deuxième film d'oxyde Ox41s, Ox141s peut être du SiₓO_{y}N_{z} et la troisième portion Ox30s du film d'oxyde 90 peut être du SiₓO_{y}, x, y, z, étant des entiers non nuls.

Comme on le verra par la suite, du fait de leur composition différente, ces portions du film d'oxyde 90 présentent des sensibilités différentes à la gravure de l'étape suivante.

Typiquement, l'épaisseur du film d'oxyde 90 est comprise entre 2 et 4 nanomètres. Cette épaisseur peut différer d'une portion à l'autre.

On notera que selon les paramètres de l'étape d'oxydation principale, en particulier avec une tension de polarisation nulle voir très faible (typiquement inférieure à 50 V ou 30 V), l'épaisseur e_{Ox141f} est égale à l'épaisseur e_{Ox30s}. Ces épaisseurs e_{Ox141f} et e_{Ox30s} sont référencées en figure 3D.

Cette étape d'oxydation principale est de préférence effectuée dans un équipement de gravure tel qu'un réacteur de gravure plasma. De préférence le réacteur est un réacteur ICP ou CCP. De préférence, cette étape d'oxydation principale est effectuée dans le même réacteur que les étapes précédentes.

Le plasma permettant l'oxydation est formé à partir d'une chimie à base d'oxygène.

De préférence, la tension de polarisation (habituellement désignée par le vocable anglais bias) est nulle ou très faible afin d'éviter d'endommager le matériau semi-conducteur de la structure 30. De manière plus générale, la tension de polarisation est inférieure à 50 V et de préférence inférieure à 30 V.

La durée de l'oxydation est de préférence comprise entre 5 et 30 secondes et de préférence comprise entre 10 et 20 secondes.

La figure 3E illustre une étape de gravure anisotrope, désignée par la suite gravure anisotrope principale. Cette gravure anisotrope présente une direction privilégiée Z perpendiculaire au plan de base XY.

Cette gravure anisotrope principale est configurée de sorte à graver les deuxièmes premières portions Ox41s, Ox141s, de sorte à découvrir puis à graver, selon la direction privilégiée Z, une partie au moins de la couche diélectrique 40 située à l'aplomb, selon la direction privilégiée Z, de la deuxième portion Ox41s, Ox141s. Les portions de couche diélectrique 40 qui sont consommées verticalement sont référencées 41', 141' en figure 3E. L'épaisseur consommée, mesurée selon la direction Z, est référencée e_{41'}.

Du fait de leurs compositions différentes, les deuxièmes portions Ox41s, Ox141s sont plus sensibles à la gravure que les troisièmes portions Ox30s. Cela s'explique par le fait que le silicium s'oxyde plus facilement que le nitrure. La quantité d'oxygène du film d'oxyde protégeant le Si est donc supérieure à la quantité du film d'oxyde recouvrant le SiN. Le film d'oxyde recouvrant le SiN se grave donc plus rapidement que le film d'oxyde recouvrant le Si.

L'épaisseur du film d'oxyde 90 est réglée de sorte que, lorsque l'épaisseur e_{Ox141s} est entièrement consommée, il subsiste une épaisseur e_{Ox30s} sur la face 31 de la structure 30. Il est alors possible de graver la couche diélectrique 41, 141 mise à nu sans pour autant consommer le matériau diélectrique de la structure 30.

La figure 3E illustre la disparition des portions Ox41s et Ox141s et l'amincissement des portions Ox141f et Ox30s causés par la gravure principale anisotrope.

Sur la figure 3E, on a illustré une portion du film d'oxyde Ox150s qui recouvre le masque dur 150. C'est effectivement le cas si le masque dur 150, ou tout au moins sa face supérieure, est faite d'un oxyde. En revanche, si cette face supérieure est faite d'un nitrure, alors la portion du film d'oxyde Ox150s se grave aisément et cette portion de film d'oxyde Ox150s aura disparu en fin d'étape de gravure anisotrope principale.

Bien qu'il soit préférable de stopper la gravure anisotrope principale avant de graver la structure 30 en un matériau semi-conducteur, il reste naturellement possible de consommer une épaisseur, très faible de la structure 30 en matériau semi-conducteur, afin de s'assurer qu'il ne reste pas de résidus de films d'oxyde sur la structure 30. Typiquement cette épaisseur consommée de la structure 30 en matériau semi-conducteur est inférieure ou égale à 1 nm et de préférence inférieure ou égale à trois couches atomiques de de la structure 30.

De manière préférée, cette gravure anisotrope principale est stoppée également avant de consommer toute l'épaisseur e_{ox141f} de la première portion du film d'oxyde Ox41f, Ox141f ou tout au moins avant de commencer à consommer latéralement la couche diélectrique 41,141 disposées sur les flancs 32,131 des parois perpendiculaires au plan de base XY. Ainsi, lors de cette étape de gravure anisotrope principale, on conserve le contrôle dimensionnel des portions 141 destinées à former les espaceurs de grille 130.

On notera également que le film d'oxyde 90 recouvre et protège la couche isolante 20 lors de l'étape de gravure anisotrope principale.

Ainsi, à l'issue de cette première séquence d'étapes, on a consommé verticalement une partie 41', 141' de la couche diélectrique 40 disposée sur les parois parallèles à la direction privilégiée Z de gravure. Pour autant, ces portions 41, 141 de couche diélectrique 40 disposées sur les parois parallèles à la direction privilégiée Z ne sont pas consommées latéralement. Elles conservent donc leur épaisseur e₁₄₁ initiale. On conserve donc le contrôle dimensionnel des portions 141 de couche diélectrique destinées à former les espaceurs 140. Par ailleurs, la structure 30 semiconductrice n'est pas consommée, ni même altérée par la gravure.

Cette gravure principale anisotrope est de préférence effectuée dans un équipement de gravure tel qu'un réacteur de gravure plasma. De préférence le réacteur est un réacteur ICP ou CCP. De préférence, cette étape est effectuée dans le même réacteur que les étapes précédentes.

Le plasma de gravure est formé à partir d'une chimie fluorocarbonée ce qui permet d'améliorer l'anisotropie de la gravure. Selon un exemple, cette chimie comprend une espèce fluorocarbonée parmi les espèces suivantes CₓH_{y}F_{z} ou CₓH_{y}, x, y et z étant des entiers non nuls. De préférence, la chimie fluorocarbonée comprend également au moins une espèce additionnelle de dilution ou de dissociation telle que l'argon (Ar), l'hélium (He), l'azote (N) ou l'oxygène (O). Cette chimie de gravure a pour avantage d'améliorer encore l'anisotropie de la gravure.

On notera que du fait de l'introduction du composant fluoré lors de la gravure, la composition des films d'oxyde conservés peut évoluer. Ainsi, si la structure 30 est à base de Si, alors la première portion Ox141f, Ox41f du film d'oxyde 90 (i.e., le film d'oxyde situé sur du nitrure), peut-être du SiₓO_{y}N_{z}C_{w}Fₜ et la troisième portion Ox30s du film d'oxyde 90 (i.e., le film d'oxyde situé sur du silicium) peut être du SiₓO_{y}C_{w}Fₜ, w, x, y, z, t, étant des entiers non nuls et w étant possiblement égal à 0 comme indiqué ci-dessus.

Cette composition n'est cependant pas limitative. En effet, la composition du film d'oxyde dépend du ratio ou de la teneur en oxygène et en carbone dans le mélange gazeux utilisé pour l'étape de gravure anisotrope principale.

Une augmentation de la concentration en oxygène dans le mélange gazeux conduit à une réduction de la teneur en carbone dans le film d'oxyde. Typiquement, si la concentration en oxygène est supérieure à 30 % dans le mélange gazeux, alors cette étape d'oxydation conduira principalement à oxyder les surfaces découvertes et la teneur en carbone du film d'oxyde sera nulle ou très faible.

Ainsi, en fonction du ratio des différents gaz et notamment de la teneur en carbone et en oxygène du mélange gazeux, à l'issue de l'étape de gravure anisotrope principale, on peut observer les compositions suivantes :
odu SixOyNzCwFt pour les portions Ox141f, Ox41f du film d'oxyde situées à la surface de la couche du matériau à base de nitrure,
odu SixOyCwFz, pour la portion couche d'oxyde de protection déposée sur un matériau à base de silicium.

Avec x, y, z et t étant des entiers, et w ≥ 0. Ainsi, on peut avoir les compositions suivantes SixOyNzFt et SixOyFt pour w = 0.

Quelle que soit la teneur en carbone, le matériau semi-conducteur s'oxyde plus facilement que le matériau à base de nitrure de la couche diélectrique. La couche d'oxyde de protection ainsi formée protège donc plus efficacement le matériau semi-conducteur que le matériau base de nitrure lors de la gravure anisotrope principale.

Le plasma peut être continu ou pulsé.

La durée de cette étape est ajustée en fonction du rapport des vitesses de gravure des couches découvertes et de l'épaisseur du film d'oxyde 90.

La séquence est réitérée jusqu'au retrait complet des portions 41 de couche diélectrique 40 située sur les flancs 32 de la structure 30 en un matériau semi-conducteur.

Ainsi, une deuxième séquence d'étapes est illustrée aux figures 3F et 3G.

La figure 3F est une oxydation principale pour reformer un film d'oxyde 90 sur toutes les surfaces découvertes.

La figure 3G est une gravure anisotrope principale effectuée de sorte à consommer verticalement la couche diélectrique 40 de préférence toute la couche diélectrique 40.

Au cours de cette gravure anisotrope principale :
ola première portion Ox141f du film d'oxyde 90 protège la couche diélectrique 40 pour éviter sa consommation latérale,
∘la troisième portion Ox30s du film d'oxyde 90 protège la structure 30 pour éviter sa consommation ou son altération.

Cette séquence est réitérée jusqu'à disparition complète des portions 41 de la couche protection 40 recouvrant les flancs 32 de la structure 30. Ainsi, la portion 41' de couche diélectrique 40 consommée verticalement présente la même épaisseur que celle e₃₀ de la structure 30.

La durée des séquences varie typiquement entre 5 secondes et 60 secondes. Cette durée dépend de l'épaisseur du film d'oxyde 90 et donc de la durée de l'étape d'oxydation principale puisque la gravure anisotrope principale doit consommer, à chaque cycle, toute l'épaisseur des premières portions Ox41s du film d'oxyde ainsi qu'une portion 41', 141' de la couche diélectrique.

Dans le cas de la réalisation d'un transistor FinFET, on souhaite conserver la couche diélectrique 40 sur les flancs de la grille 130 tout en retirant entièrement la couche diélectrique 40 sur les Fins 30. Or, les flancs 131 de la grille 130 et les flancs 32 du Fin 30 sont généralement perpendiculaires au plan principal XY du substrat de support 10 et sont généralement parallèles à la direction principale (Z) d'implantation des ions issus du plasma. Afin d'éviter de consommer la couche diélectrique 40 sur les flancs de la grille 130 lors du retrait de cette même couche sur les flancs des Fins 30, on prévoit que l'épaisseur e₁₅₀ du masque dur 150 surmontant la grille 130 soit supérieure ou égale à l'épaisseur e₃₀ du Fin 30. Ainsi, lorsque la couche diélectrique 40 recouvrant les flancs 32 du Fin 30 sera entièrement consommée, la couche diélectrique 40 aura été consommée sur une partie au moins de l'épaisseur du masque dur mais continuera de recouvrir intégralement les flancs de la grille 130.

La figure 4 reprend, sous forme d'un ordinogramme, les étapes principales du mode de réalisation illustré en référence aux figures 3A à 3G.

De préférence, toutes les étapes de ce mode de réalisation sont réalisées dans le même réacteur plasma, ce qui permet de réduire les cycles de fabrication et de réduire le cout de mise en œuvre du procédé.

Les tableaux ci-dessous donnent des valeurs, optionnelles et non limitatives, d'un exemple de mise en oeuvre du procédé illustré en référence aux figures 3A à 3G.

**Tableau 1**

| Oxydation principale (figures 3D et 3F) : | |
|---|---|
| Nature de la couche diélectrique 40 | SiN |
| Nature de la structure 30 semi-conducteur | Si |
| Épaisseur du film d'oxyde 90 formé par oxydation | Par exemple 2 à 4nm |
| Chimie : | O2: 200 sccm |
| Type de plasma | ICP, CCP, pulsé ou continu |
| Puissance de la source : | 1000 Watts |
| Tension de polarisation (bias) : | 0 Volts |
| Pression : | 10 milli Torr |
| Température du substrat de support : | par exemple 50°C |
| Temps : | 10 secondes |

Comme indiqué précédemment, une tension de polarisation nulle permet d'éviter, ou à tout le moins de limiter la consommation de silicium.

**Tableau 2**

| Gravure principale anisotrope (figures 3E et 3G) : | |
|---|---|
| Chimie du plasma : | CH2F2: 95 sccm |
| | O2: 63 sccm |
| | He: 50 sccm |
| Type de plasma | ICP |
| Puissance de la source : | 400 Watts |
| Tension de polarisation (bias) : | 100 Volts |
| Pression : | 40 milli Torr |
| Température du substrat de support : | 50°C |
| Temps : | 30 secondes |

Le rapport des débits injectés dans le réacteur concernant les gaz CH2F2 et O2 est choisi de manière à augmenter la sélectivité de la gravure du SiN par rapport au Si, ceci afin de limiter la consommation de Si.

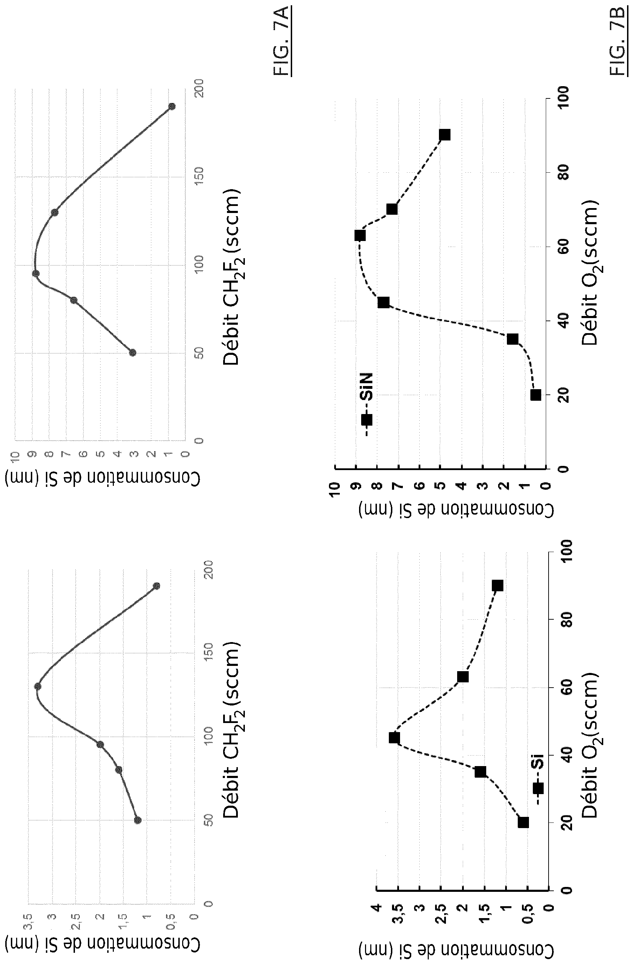

Pour effectuer ce choix, on pourra par exemple s'appuyer sur des graphes tels que illustrés en figures 7A et 7B.

Les graphes de la figure 7A illustrent, en fonction du débit du gaz CH2F2 injecté dans le réacteur, les épaisseurs consommées de Si et SiN respectivement.

Ces graphes de la figure 7A sont obtenus avec les conditions suivantes et en faisant varier le débit de CH2F2.

**Tableau 3**

| | |
|---|---|
| Chimie du plasma : | CH2F2: variable - voir abscisse du graphe |
| | O2: 63 sccm |
| | He: 50 sccm |
| Type de plasma | ICP |
| | |
| Puissance de la source : | 400 Watts |
| Tension de polarisation (bias) : | 100 Volts |
| Pression : | 40 milli Torr |
| Température du substrat de support : | par exemple 50°C |
| Temps : | 30 secondes |

Les graphes de la figure 7B illustrent, en fonction du débit du gaz O2 injecté dans le réacteur, les épaisseurs consommées de Si et SiN respectivement.

Ces graphes de la figure 7B sont obtenus avec les conditions suivantes et en faisant varier le débit de O2:

**Tableau 4**

| | |
|---|---|
| Chimie du plasma : | CH2F2: 95 sccm |
| | O2: variable - voir abscisse du graphe |
| | He: 50 sccm |
| Type de plasma | ICP |
| | |
| Puissance de la source : | 400 Watts |
| Tension de polarisation (bias) : | 100 Volts |
| Pression : | 40 milli Torr |
| Température du substrat de support : | 50°C |
| Temps : | 30 secondes |

Au regard de ces graphes des figures 7A et 7B, il ressort que les conditions les plus avantageuses sont celles mentionnées dans le tableau Il ci-dessus.

Par ailleurs, on peut également ajouter du CH4 dans la chimie formant le plasma. Il s'est avéré que cela permet d'améliorer la sélectivité de la gravure du SiN vis-à-vis du Si. Pour l'exemple mentionné ci-dessus, un débit de 20 sccm CH4 permet d'obtenir une sélectivité particulièrement élevée.

La durée des séquences varie typiquement entre 5 secondes et 60 secondes. Cette durée dépend principalement de la durée de l'étape d'oxydation principale. Par exemple, si la durée de l'étape d'oxydation principale est de 10 secondes, alors la durée de la gravure anisotrope principale peut-être de 60 secondes.

Le mode de réalisation qui a été décrit en détail ci-dessus, permet de retirer avec une grande précision, avec un nombre restreint d'étapes et avec une grande fiabilité, la couche diélectrique 40 sur la structure 30 tout en conservant le contrôle dimensionnel de la couche diélectrique destinée à former les espaceurs de grille.

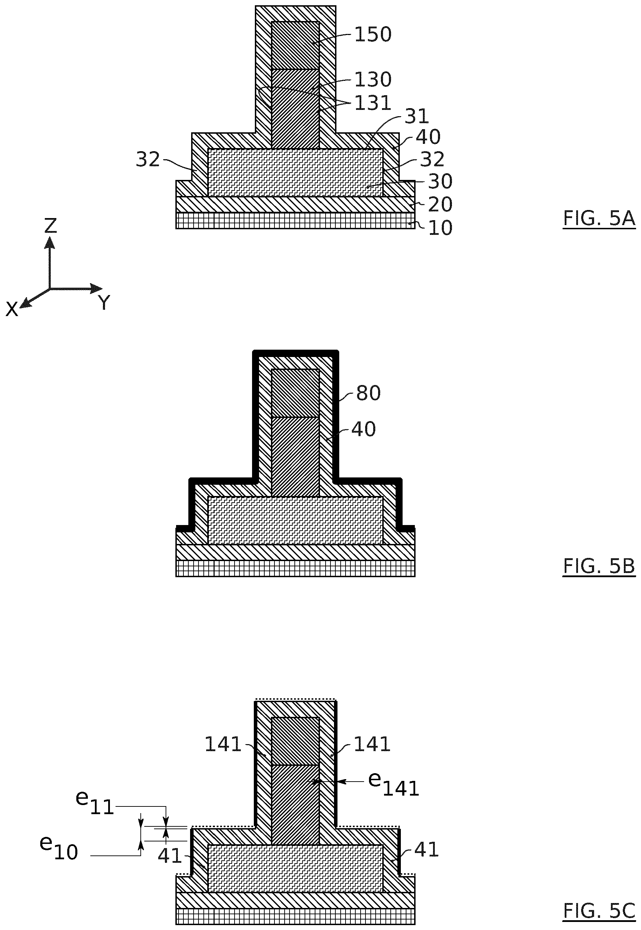

Un autre mode de réalisation va maintenant être décrit en référence aux figures 5A à 5L.

Sauf mention contraire, toutes les caractéristiques, étapes et avantages mentionnés ci-dessus relativement aux modes de réalisation décrits en référence aux figures 3A à 3G sont applicables aux modes de réalisation décrits en référence aux figures 5A à 5L.

Dans ce mode de réalisation, la couche diélectrique 40 peut être poreuse ou non. Elle est par exemple formée dans l'un des matériaux suivants : SiCO, SiC, SiCN, SiOCN ou SiCBN, ou un nitrure de silicium (SixNy, x et y étant des entiers non nuls), typiquement du SiN.

La figure 5A est identique à la figure 3A.

La figure 5B est identique à la figure 3B et illustre l'étape optionnelle d'oxydation préalable.

Toutes les caractéristiques mentionnées en référence aux figures 3A et 3B sont pleinement applicables au mode de réalisation illustrés en figures 5A à I.

La figure 5C illustre l'étape optionnelle de gravure initiale, anisotrope, de la couche diélectrique 40. Cette étape de gravure initiale diffère de celle décrite en référence à la figure 3C en ce qu'elle ne consomme pas toute l'épaisseur e₁₀ de la couche diélectrique 40 située sur la face 31 de la structure 30.

Comme illustré en figure 5C cette gravure initiale, anisotrope, consomme une épaisseur e₁₁ inférieure à e₁₀.

Comme pour la gravure initiale illustrée en référence à la figure 3C, dans le mode de réalisation illustrée en figure 5C, la gravure initiale anisotrope consomme latéralement, de manière inévitable, le film d'oxyde initial 80.

Néanmoins, cette gravure initiale anisotrope est stoppée avant que le film d'oxyde initial 80 découvre les portions 141 de la couche diélectrique 40 situées sur les flancs 131 de la grille 30 comme cela est illustré en figure 5C. Alternativement, on peut prévoir de stopper la gravure initiale anisotrope après consommation latérale de toute l'épaisseur du film d'oxyde initial 80 mais avant que la consommation de ces portions 141 ne puisse altérer les propriétés des espaceurs.

Cette gravure initiale permet d'augmenter la rapidité du procédé avant les étapes ultérieures qui vont permettre une gravure très précise. Typiquement, au cours de cette étape préalable de gravure, plus de 70 % et de préférence plus de 90 % et encore plus préférentiellement plus de 90 % de l'épaisseur initiale e₁₀ de la couche diélectrique 40 est gravée. L'épaisseur e₁₁ retirée au cours de cette gravure est de préférence contrôlée au temps. Pour des raisons de clarté l'épaisseur gravée e₁₁ illustrée en figure 5C est volontairement représentée de manière réduite.

À l'issue de la gravure initiale anisotrope, la face 31 supérieurs de la structure 30, e.g., le sommet des Fin dans le cas d'un transistor FinFET, est recouverte par une épaisseur résiduelle de la couche diélectrique 40. Typiquement, à l'issue de la gravure, la couche diélectrique 40 présente une épaisseur résiduelle supérieure à 2 nm, de préférence supérieure à 3 nm et de préférence supérieure à 4 nm. Typiquement, l'épaisseur résiduelle est comprise entre 2 et 3 nm. Cette épaisseur résiduelle permet d'éviter que lors de la gravure, les couches sous-jacentes à la couche diélectrique 40 soient endommagées.

Cette étape de gravure par plasma est basée sur une chimie comprenant un composé à base de fluor (F). De préférence, cette chimie comprend une espèce fluorocarbonée, par exemple pris parmi les espèces suivantes CxHyFz ou CxHy, x, y et z étant des entiers non nuls. Cette chimie de gravure a pour avantage d'améliorer l'anisotropie de la gravure. Cette anisotropie permet de ne pas graver les surfaces qui sont parallèles à la direction privilégiée d'implantation, typiquement les futurs espaceurs du transistor.

De préférence, la chimie fluorocarbonée comprend également au moins une espèce additionnelle de dilution ou de dissociation telle que l'argon (Ar), l'hélium (He), l'azote (N) ou l'oxygène (O).

Le plasma peut être continu ou pulsé.

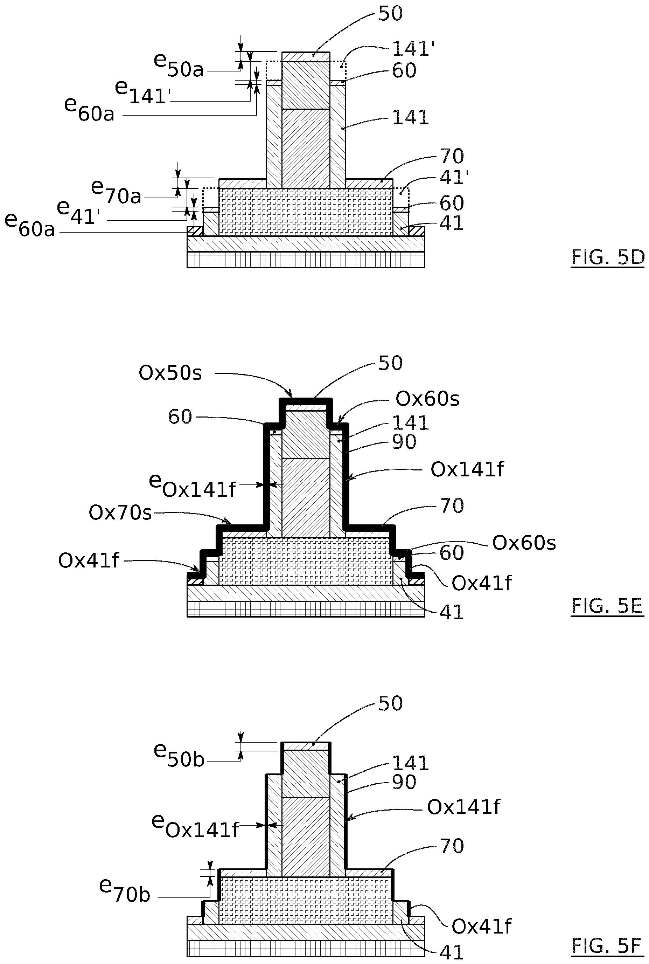

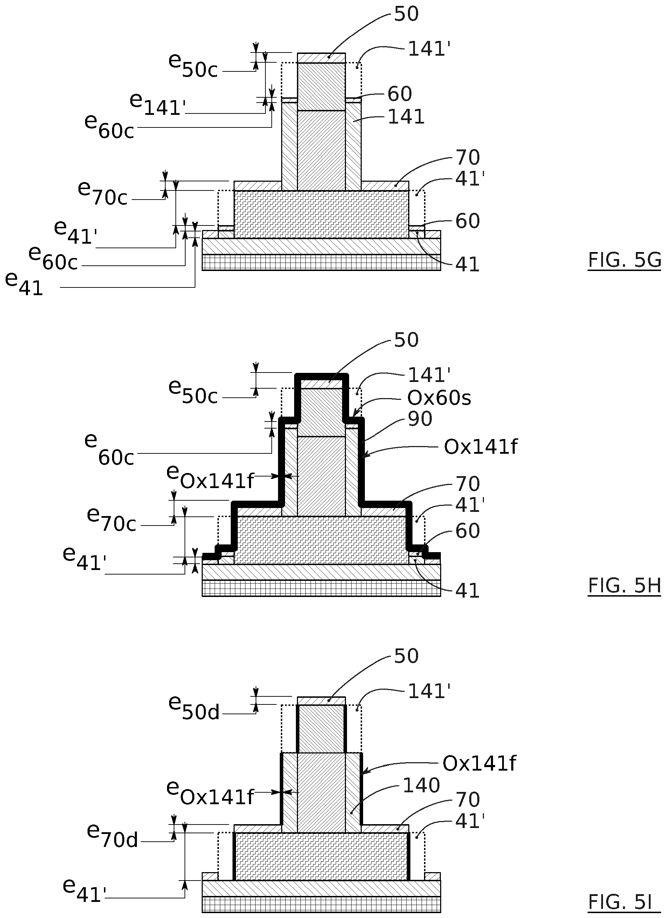

Les figures 5D à 5F illustrent différentes étapes d'une séquence d'étapes qui peut être réitérée jusqu'à obtenir le résultat qui est illustré en figure 5I.

La première séquence d'étapes est effectuée à l'issue de la gravure initiale optionnelle (Figure 5C), ou après le dépôt de la couche diélectrique 40 (Figure 5B), dans le cas où il n'y a pas de gravure initiale.

Comme illustré en figure 5D, on effectue une gravure préalable de la couche diélectrique 40.

Cette gravure préalable est configurée de manière à graver le matériau de la couche diélectrique 40 préférentiellement au matériau de la structure 30 en matériau semi-conducteur. Ainsi, à l'issue de cette gravure préalable, l'épaisseur gravée e_{41'} du matériau de la couche diélectrique 40 est supérieure à l'épaisseur gravée du matériau semi-conducteur de la structure 30.

Par ailleurs, cette gravure préalable est configurée de manière à :
os'interrompre avant de consommer toute l'épaisseur de la couche diélectrique 40 située sur le flanc 32 de la structure 30 ;
∘former une première couche d'oxyde de protection 60 sur une portion supérieure de la couche diélectrique 40 située sur les flancs 32 et à former une deuxième couche d'oxyde de protection 70 sur le sommet 31 de la structure 30 en un matériau semi-conducteur, l'épaisseur e₆₀ₐ de la première couche de protection 60 étant inférieure à l'épaisseur e₇₀ₐ la deuxième couche de protection 70.

Ces première 60 et deuxième 70 couches de protection sont formées de dépôts d'oxyde. Elles peuvent ainsi être qualifiées de couche d'oxyde de protection. Néanmoins, ces première 60 et deuxième 70 couches de protection diffèrent de simple oxydation des surfaces découvertes.

Cette gravure préalable est de préférence une gravure plasma. Elle utilise une chimie comprenant au moins :
oau moins un premier composé à base de fluor (F) et
oau moins un deuxième composé pris parmi le Si_{w}Cl_{(2w+2)} et le Si_{w}F_{(2w+2)} w étant un entier,
ode l'oxygène (O).

Le premier composé à base de fluor permet une gravure efficace de la couche diélectrique 40 avec une bonne anisotropie.

Le deuxième composé permet d'améliorer la sélectivité de la gravure de la couche diélectrique vis-à-vis des couches sous-jacentes, par exemple faite d'un matériau semi-conducteur ou d'oxyde de silicium (SiO2).

La quantité du premier composé à base de fluor est régulée de manière à consommer tous les composés à base de fluor, et donc à interrompre la première gravure avant de consommer toute l'épaisseur (prise selon l'axe Z) de la couche diélectrique 40 qui située sur les flancs 32. Selon un mode de réalisation particulièrement avantageux, le premier composé à base de fluor a été intégralement introduit lors de l'étape de gravure initiale illustrée en figure 5C. Le fluor subsistant à l'issue de cette étape préalable de gravure est utilisé lors de ladite première gravure jusqu'à être entièrement consommé.

Alternativement, une partie ou l'intégralité des composés à base de fluor consommé lors de cette première gravure est introduite dans le réacteur plasma durant cette première gravure.

La présence d'oxygène dans la chimie du plasma permet d'oxyder toutes les a surfaces mises à nu. Au cours de la gravure, une épaisse couche d'oxyde de protection se forme sur le Si, alors qu'une couche d'épaisseur plus faible se forme sur le SiN. Au cours de l'étape de gravure anisotrope principale ces deux couches d'oxyde vont croître et la différence de leur épaisseur augmente également. Cette oxydation forme des couches de protection référencées :
o60 sur les portions supérieures de la couche diélectrique 40 située sur les flancs 32 du Fin 30. Cette couche de protection 60 est par exemple de type SixOyNzFt, si la couche diélectrique 40 est à base de SiN ;
o70 sur le sommet 31 de la structure 30. Cette couche de protection 70 est par exemple de type SixOyFz, si la structure 30 est à base de silicium.
o50 sur le sommet du masque dur surface de la couche isolante 20.

Par ailleurs, si la couche isolante 20 est à base de SixOy, ce dépôt d'oxyde peut former sur cette dernière une couche d'oxyde de protection 70 en SixOyFz.

Le matériau semi-conducteur de la structure 30 est plus réactif à l'oxygène que le matériau de la couche diélectrique 40, typiquement un nitrure. Il s'ensuit que l'épaisseur e₇₀ de la couche de protection 70 formée sur le sommet 31 de la structure 30 est supérieure à l'épaisseur e₆₀ formée sur la portion supérieure de la couche diélectrique 40 située sur les flancs 32 de cette structure 30.

Ainsi, la deuxième couche de protection 70 présente une épaisseur e₇₀ supérieure à celle e₆₀ de la première couche protection 60. Typiquement, e₇₀ ≥k1. e₆₀, avec k1 = 1.5 et de préférence k1 = 2 et de et de préférence k1 = 3.

De manière avantageuse, la couche de protection formée sur la surface de la couche isolante 20 présente une épaisseur supérieure à celle e₆₀ de la couche de protection 60 située sur la couche diélectrique 40.

De préférence, la chimie utilisée pour cette première gravure comprend également des espèces de dilution ou de dissociation telle que l'argon, l'hélium ou l'azote.

Le plasma peut être continu ou pulsé. De manière générale, un plasma pulsé permet de limiter l'endommagement du matériau semi-conducteur de la structure 30.

Par exemple, au cours de cette gravure, on utilise pour le plasma une chimie comprenant :
odu CyHyFz, par exemple du CH3F,
odu SiCl4 dont le débit est compris entre 2 et 15 et de préférence de l'ordre de 5 sccm,
ode l'oxygène,
oéventuellement un gaz de dissociation telle que l'Ar, l'He ou le N2.

La figure 5E, illustre une étape d'oxydation pour former un film d'oxyde 90 recouvrant toute les surfaces découvertes. Cette étape d'oxydation correspond à l'oxydation principale décrite en référence à la figure 3D.

Ainsi, ce film d'oxyde 90 est formé par oxydation des surfaces découvertes. Ce film d'oxyde 90 présente donc des compositions différentes en fonction de la nature des surfaces oxydées. Comme pour la figures 3D, le film d'oxyde 90 est représenté de manière exagérément épaisse pour faciliter l'explication de l'invention.

Ainsi, ce film d'oxyde 90 présente :
oau moins une première portion Ox41f, Ox141f formée à la surface de la couche diélectrique 40 et s'étendant dans un plan perpendiculaire YZ, ZX au plan de base XY. Typiquement, les premières portions Ox41f, Ox141f sont formées par oxydation de la couche diélectrique recouvrant les flancs 32,131 de la structure 30 et de la grille 130.
oau moins une deuxième portion Ox60s formée à la surface de la couche d'oxyde de protection 60 recouvrant la couche diélectrique 40. Ces deuxièmes portions présentent, en projection selon une direction perpendiculaire Z au plan de base XY, une surface non nulle. Typiquement, les deuxièmes portions Ox60s sont formées par oxydation de l'épaisseur de la couche d'oxyde de protection 60 recouvrant les parois perpendiculaires au plan de base XY.
oau moins une troisième portion Ox70s formée par oxydation de la couche d'oxyde de protection 70 surmontant la structure 30 en matériau semi-conducteur. Cette troisième portion Ox70s présente, en projection selon une direction perpendiculaire Z au plan de base (XY), une surface non nulle.

On notera également que le film d'oxyde 90 peut présenter une portion Ox50s formée par oxydation de la couche d'oxyde de protection 50 surmontant le masque dur 150 recouvrant la grille 130.

Comme cela sera détaillé par la suite, cette étape d'oxydation principale a notamment pour intérêt de protéger la couche diélectrique 40 s'étendant dans des plans parallèles YZ, ZX à la direction privilégiée Z de gravure anisotrope. Cette protection permet de limiter la consommation latérale, involontaire mais inévitable, de la couche diélectrique lors de l'étape de gravure subséquente.

Typiquement, si la couche diélectrique est en SiₓN_{y}, alors les premières portions Ox41f, Ox141f du film d'oxyde peuvent être du SiₓO_{y}N_{z}Fₜ x, y, z, t, étant des entiers.

Typiquement, l'épaisseur du film d'oxyde 90 est comprise entre 2 *et 4* nanomètres. On notera que selon les paramètres de l'étape d'oxydation principale, en particulier avec une tension de polarisation nulle voir très faible (typiquement inférieure à 50 V ou 30 V), l'épaisseur est sensiblement égale sur toutes les surfaces. Ainsi on pourra avoir une épaisseur e_{Ox141f} égale à l'épaisseur e_{Ox30s}.

Cette étape d'oxydation principale est de préférence effectuée dans un équipement de gravure telle qu'un réacteur de gravure plasma. De préférence le réacteur est un réacteur ICP ou CCP. De préférence, cette étape d'oxydation principale est effectuée dans le même réacteur que les étapes précédentes.

Le plasma permettant l'oxydation est formé à partir d'une chimie à base d'oxygène.

De préférence, la tension de polarisation (habituellement désignée par le vocable anglais bias) est nulle ou très faible afin d'éviter d'endommager le matériau semi-conducteur de la structure 30. De manière plus générale, la tension de polarisation est inférieure à 50 V et de préférence inférieure à 30 V.

La durée de l'oxydation est de préférence comprise entre 5 et 30 secondes et de préférence comprise entre 10 et 20 secondes.

Comme illustré en figure 5F, à l'issue de la première gravure, on effectue une deuxième gravure.

Cette gravure, désignée par la suite gravure anisotrope principale, correspond à la gravure décrite ci-dessus en référence à la figure 3E.

Cette gravure anisotrope principale vise à retirer entièrement la première couche d'oxyde de protection 60 située sur la portion supérieure de la couche diélectrique 40 recouvrant les flancs 32 des Fins 30 tout en conservant une portion e_{70b} de la deuxième couche d'oxyde de protection 70 sur la face 31 supérieure de la structure 30, e.g., les Fin du transistor FinFET.

Cet objectif est d'autant plus facilement atteint que l'épaisseur e₇₀ de la deuxième couche d'oxyde de protection 70 est plus épaisse que celle e₆₀ de la première couche d'oxyde de protection 60.

De préférence, au cours de cette étape, on conserve également une portion (non illustrée) de l'épaisseur de la couche d'oxyde de protection formée au-dessus de la couche isolante 20.

Cette étape est contrôlée au temps.

Typiquement, au cours de l'étape de préalable décrite ci-dessus, une épaisseur d'au moins 1 nm et de préférence d'au moins 1 nm de la couche d'oxyde de protection 70 est consommée.

De préférence, cette épaisseur consommée au cours de cette deuxième gravure est inférieure à 8 nm et de préférence inférieure à 4 nm et de préférence inférieure à 2 nm.

De préférence, cette étape est effectuée de manière à ce que la couche d'oxyde de protection 70 conservée pour protéger le sommet 31 des Fin présente une épaisseur résiduelle e_{70b} telle que e_{70b} ≥ 1 nm et de préférence e_{70b} ≥ 2 nm. Cette épaisseur permet de protéger efficacement les Fin 30.

Cette étape de gravure anisotrope principale est par exemple effectuée dans un équipement de gravure de type réacteur plasma à couplage inductif (ICP), ou réacteur plasma à couplage capacitif (CCP). De préférence elle est effectuée dans le même réacteur que les étapes précédentes.

Cette étape de gravure est basée sur une chimie comprenant un composé à base de fluor (F). De préférence, cette chimie comprend une espèce fluorocarbonée, par exemple pris parmi les espèces suivants CxHyFz ou CxHy, x, y et z étant des entiers, tel que le CF4 par exemple ainsi, on pourra utiliser la même chimie que pour l'étape préalable de gravure, de préférence avec une tension de polarisation (habituellement désignée bias) plus faible qu'au cours de la gravure préalable, ceci afin de limiter la consommation des couches sous-jacentes, en particulier de la couche en matériau semi-conducteur.

Il est également possible d'utiliser des chimies à base de SxFy, tel que le SF6. Il faut cependant s'assurer que la gravure avec ce type de chimie ne soit pas trop rapide afin de ne pas endommager la couche de matériau semi-conducteur.

De préférence, la chimie fluorocarbonée comprend également au moins une espèce additionnelle de dilution ou de dissociation telle que l'argon (Ar), l'oxygène (O), l'hélium (He) ou l'azote (N). L'argon peut avoir pour inconvénient de rendre la vitesse de gravure trop élevée. Typiquement, l'épaisseur, prise selon la direction Z, de la couche d'oxyde de protection que l'on grave au cours de cette gravure anisotrope principale est inférieure à 4 nm et de préférence inférieure à 2 nm. Typiquement, la vitesse de gravure de la couche d'oxyde de protection est de l'ordre de 10 nm/m.

Cette gravure anisotrope principale est interrompue, en contrôlant sa durée :
∘avant que toute la couche d'oxyde de protection 70 soit consommée, ou tout au moins avant de commencer à consommer la structure 30 en matériau semi-conducteur sous-jacente ou tout au moins avant d'en consommer une épaisseur de structure 30 susceptible de dégrader les performances du transistor ;
∘avant que tout le film d'oxyde Ox141f soit consommé, ou tout au moins avant de commencer à consommer latéralement les portions 141 de couche diélectrique s'étendant parallèlement à la direction privilégiée Z de la gravure; ou tout au moins avant d'en consommer une épaisseur susceptible de dégrader les performances des espaceurs.

Sur la figure 5F, on a illustré le cas où la gravure anisotrope principale est stoppée avant consommation de toute l'épaisseur de la couche d'oxyde de protection 70 (il reste une épaisseur e_{70b}), et avant consommation de toute l'épaisseur de la première portion Ox141f du film d'oxyde 90 (il reste une épaisseur e_{Ox141f}).

Ainsi, ces deux conditions sont observées pour déterminer le moment de l'arrêt de la gravure anisotrope principale. Il s'agit en effet d'éviter :
∘une consommation ou une consommation excessive, verticale, de la structure 30 en matériau semi-conducteur,
∘une consommation ou une consommation excessive, latérale, de la couche diélectrique 40.

À l'issue de cette gravure anisotrope principale, la séquence d'étapes comprenant la gravure préalable, l'oxydation principale et la gravure anisotrope principale est réitérée.

Tout au long de chaque séquence :
ola face 31 supérieure de la structure 30 reste protégée par la couche d'oxyde de protection 70 formée par dépôt lors de la gravure préalable de chaque séquence,
∘les parois latérales des portions 141 de la couche diélectrique qui s'étendent perpendiculairement au plan de base XY, restent protégées par la première portion Ox141f du film d'oxyde 90.

De préférence, il en est de même pour la face supérieure de la couche isolante 20 qui reste protégée par la couche d'oxyde de protection 90.

En revanche, au cours de chaque étape de gravure préalable, les portions 41 de couche diélectrique 40 recouvrant les flancs 32 du Fin 30 ont quant à elle été fortement consommées selon la direction privilégiée Z de gravure.

Les figures 5G à 5I illustrent une séquence additionnelle.

La figure 5G illustre le résultat de la gravure préalable de cette séquence additionnelle. On voit sur cette figure que l'épaisseur de la structure 30 n'a pas été consommée et que sa face 31 supérieure est toujours recouverte par une couche d'oxyde de protection 70 dont l'épaisseur e_{70c} a augmenté par rapport à celle e_{70b} de l'étape précédente. Les portions 41 de couche diélectrique 40 recouvrant les flancs 32 de la structure 30 ont quant à elles été significativement consommées 41'.

La figure 5H illustre le résultat de l'oxydation principale avec la formation du film d'oxyde 90.

La figure 5I illustre le résultat que l'on obtient à l'issue d'une gravure anisotrope principale après avoir réitéré la séquence d'étapes. Comme illustré, les portions 41 de couche diélectrique 40 recouvrant les flancs 32 du Fin 30 sont entièrement consommées. En revanche, la hauteur e₃₀ du Fin 30 n'a pas été consommée ou n'a été que très peu consommée. Par ailleurs, la portion Ox141f du film d'oxyde 90 a efficacement protégé les portions 141 de la couche diélectrique recouvrant les flancs de la grille 130. On a ainsi parfaitement conservé le contrôle dimensionnel de la couche diélectrique 40 formant désormais des espaceurs 140 sur les flancs de la grille 130.

On peut ensuite retirer les couches d'oxyde de protection 50, 70, et éventuellement 60 si elle demeure. Pour cela on pourra par exemple procéder à un retrait par voie humide, par exemple en utilisant un bain HF (acide fluorhydrique). Dans ce cas il est possible que l'on ait une légère consommation de la couche isolante 20 mais les couches de protection à base d'oxyde 50, 60, 70 se graveront plus vite. En effet les couches de protection à base d'oxyde 50, 60, 70 sont peu denses de par leur mode de dépôt. Elles se gravent ainsi beaucoup plus vite qu'une BOX

Dans le cas de la réalisation d'un transistor FinFET, et comme indiqué dans le mode de réalisation décrits en référence aux figures 3A à 3G, on prévoit que l'épaisseur e₁₅₀ du masque dur 150 surmontant la grille 130 soit supérieure ou égale à l'épaisseur e₃₀ du Fin 30, ceci afin que les flancs 131 de la grille 130 restent entièrement recouverts par la couche diélectrique 141, même après gravure intégrale de la couche diélectrique 41 recouvrant les flancs 32 du Fin 30.

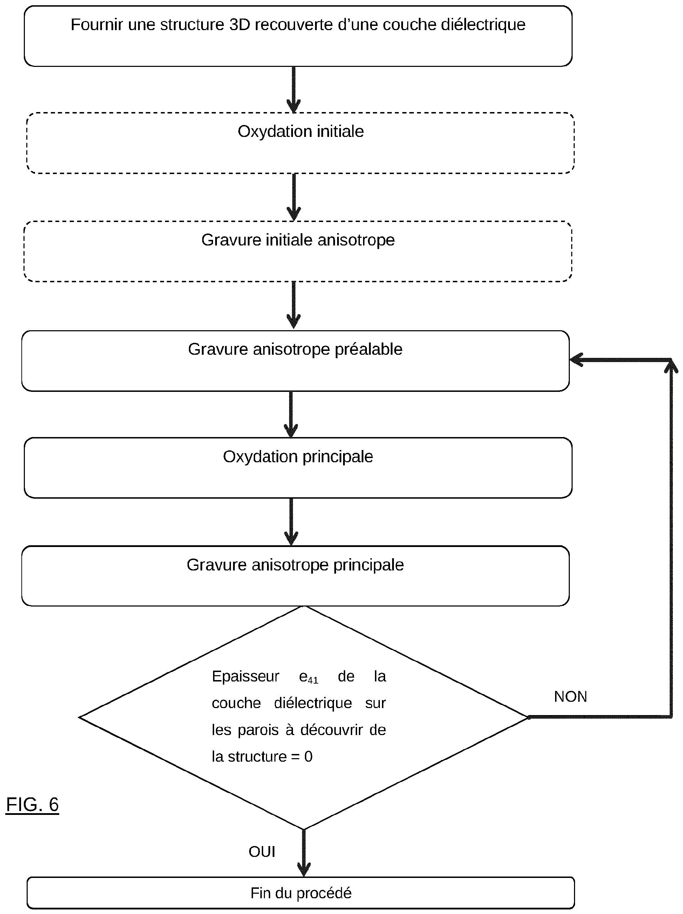

La figure 6 reprend, sous forme d'un ordinogramme, les étapes principales du mode de réalisation illustré en référence aux figures 5A à 5I.

De préférence, toutes les étapes de ce mode de réalisation sont réalisées dans le même réacteur plasma, ce qui permet de réduire les cycles de fabrication et de réduire le coût de mise en oeuvre du procédé.

Un exemple non limitatif de réalisation va maintenant être décrit.

Le matériau de la couche diélectrique est du nitrure de silicium SiN. Le matériau semi-conducteur de la structure 3D (Fin 30 dans cet exemple) est du silicium (Si). On notera que les matériaux suivants pour également convenir à l'exemple mentionné ci-dessous, SiC, SiCN, ou SiCBN.

L'épaisseur initiale e₃₀ du Fin 30 est d'environ 32 et 56 nm. La couche diélectrique 40 présente une épaisseur e₁₀ initiale comprise entre 8 et 12 nanomètres, et d'environ 8 nm dans cet exemple.

La gravure préalable, dont le résultat est illustré en figure 5C peut être opérée en mettant en oeuvre les conditions suivantes :

**Tableau 5**

| Gravure initiale (Figure 5C) | |
|---|---|
| Épaisseur de SiN conservée à l'issue de la gravure: | 2-3 nm |
| Épaisseur e₁₁ de SiN gravée: | 6 nm |
| Chimie : | CHF3: 30 sccm |
| | He: 220 sccm |
| Type de plasma | ICP, CCP, pulsé ou continu |
| Puissance de la source : | 300 Watts |
| Tension de polarisation (bias) : | 65 Volts |
| Pression : | 5 milli Torr |
| Température du substrat de support : | 60°C |
| Temps : | 20 secondes |

Les séquences d'étapes dont le résultat est illustré en figure 5I peuvent être opérées en mettant en oeuvre les conditions suivantes :

**Tableau 6**

| Séquence d'étapes : Gravure préalable (Figures 5D, 5G) | |
|---|---|
| Chimie : | CHF3: 200 sccm ou autre gaz de type CxHyFz |
| | O2: 200 sccm |
| | He: 120 sccm |
| | CH4: 0 à 20 sccm |
| | SiCl4: 5 sccm et plus généralement entre 2 et 15 sccm |
| Type de plasma | ICP, CCP |
| Plasma pulsé | Pulsé entre 10% et 90% ; de préférence 50% |
| | à 200Hz à 5kHz, de préférence 500Hz |
| Puissance de la source : | 400 Watts |
| Tension de polarisation (bias) : | 250 Volts |
| Pression : | 10 à 100 milli Torr, de préférence 90 milli Torr |
| Temps : | Entre 10 et 30s, de préférence 20 secondes |
| Température du substrat de support : | 60°C entre 20°C et 100°C |

Lors de cette étape, le plasma peut être continu ou pulsé. Un plasma pulsé permet de limiter plus efficacement l'endommagement de la couche de silicium. La fréquence du plasma pulsé est de préférence comprise entre 200 Hz et 5 kHz, de préférence de l'ordre de 500 Hz, avec un taux d'activation de 10% à 90% et typiquement de 50%.

Typiquement, au cours de cette première étape de gravure, on grave une épaisseur de SiN sur les flancs 32 du Fin 30 d'environ 5 nm. On grave une épaisseur de SiN sur le sommet 31 du Fin 30 d'environ 5 nm.

**Table 7**

| Oxydation principale (Figures 5E, 5H) | |
|---|---|
| Nature de la couche diélectrique 40 | SiN |
| Nature de la structure 30 semiconductrice | Si |
| Épaisseur du film d'oxyde 90 formé par oxydation | 2à 4 nm par exemple |
| Chimie : | O2: 200 sccm |
| Type de plasma | ICP, CCP, pulsé ou continu |
| Puissance de la source : | 1000 Watts |
| Tension de polarisation (bias) : | 0 Volts |
| Pression : | 10 milli Torr |
| Température du substrat de support : | 50°C |
| Temps : | 10 secondes |

Comme indiqué précédemment, une tension de polarisation nulle permet d'éviter, ou à tout le moins de limiter la consommation de silicium.

**Table 8**

| Gravure anisotrope principale (Figures 5F, 5I) | |
|---|---|
| Chimie du plasma : | CHF3: 30 sccm |
| | He: 220 sccm |
| Type de plasma | ICP |
| | |
| Puissance de la source : | 300 Watts |
| Tension de polarisation (bias) : | 65 Volts |
| Pression : | 5 milli Torr |
| Température du substrat de support : | 60°C |
| Temps : | 3 secondes |

En alternative, les conditions du tableau suivant peuvent également être appliquées :

**Table 9**

| | |
|---|---|
| Chimie du plasma : | CH2F2: 95 sccm |
| | O2: 63 sccm |
| | He: 50 sccm |
| | CH4: 20 sccm |
| Type de plasma | ICP |
| | |
| Puissance de la source : | 400 Watts |
| Tension de polarisation (bias) : | 100 Volts |
| Pression : | 40 milli Torr |
| Température du substrat de support : | 60°C |
| Temps : | 30 secondes |

De préférence, toutes les étapes de ce mode de réalisation sont réalisées dans le même réacteur plasma, ce qui permet de réduire les cycles de fabrication et de réduire le cout de mise en oeuvre du procédé.

Le mode de réalisation qui a été décrit en détail ci-dessus en référence aux figures 5A à 5I et 6, permet de graver rapidement la couche diélectrique selon la direction privilégiée de gravure, tout en contrôlant avec une grande précision encore améliorée le contrôle dimensionnel de la couche diélectrique destinée à former les espaceurs de grille.

Au vu de la description qui précède, il apparaît clairement que la présente invention propose une solution efficace pour graver entièrement et avec une grande précision la couche diélectrique sur le sommet et les faces d'une structure 3D tout en évitant à la fois d'endommager cette structure 3D et à la fois de consommer latéralement la couche diélectrique recouvrant des parois parallèles à la direction privilégiée d'implantation. Typiquement, la gravure de la couche diélectrique se fait avec une précision atomique ou proche de la monocouche gravée.

L'invention n'est pas limitée aux modes de réalisation précédemment décrits et s'étend à tous les modes de réalisation couverts par les revendications.

Par exemple, le procédé peut ne pas comprendre d'étape initiale de gravure.

Bien qu'elle trouve pour application particulièrement avantageuse la réalisation des transistors de type FinFET, l'invention s'applique à toutes les gravures d'une couche diélectrique présentant une structure en trois dimensions. Ainsi, elle trouvera pour application la réalisation de nanofils par exemple.

## Revendications

1. Procédé de gravure d'une couche diélectrique (40) recouvrant au moins partiellement un flanc (32, 32) d'au moins une structure (30) en un matériau semi-conducteur, les flancs (32, 32) s'étendant dans des plans perpendiculaires (YZ, ZX) à un plan de base (XY) sur lequel repose la structure (30), la structure (30) présentant au moins une face (31) non perpendiculaire au plan de base (XY)
**caractérisé par le fait qu'**il comprend une pluralité de séquences comprenant chacune au moins les étapes successives suivantes, et dans lequel préalablement à ladite pluralité de séquences, la couche diélectrique (40) recouvre les flancs (32, 32) de ladite structure, et au moins une portion de la face (31) de ladite structure (30) n'est pas recouverte par la couche diélectrique (40) :
- une oxydation principale, notamment de la couche diélectrique (40), de manière à former un film d'oxyde (90) recouvrant la structure (30), le film d'oxyde (90) présentant au moins:
- au moins une première portion (Ox41f) formée à la surface de la couche diélectrique (40) et s'étendant dans un plan perpendiculaire (YZ, ZX) au plan de base (XY),
- au moins une deuxième portion (Ox41s, Ox141s, Ox60s) formée sur la couche diélectrique (40) et présentant, en projection sur le plan de base (XY), une surface non nulle,
- au moins une troisième portion (Ox30s, Ox70s) formée sur ladite portion de la face (31) qui n'est pas recouverte par la couche diélectrique (40) préalablement à ladite pluralité de séquences, l'au moins une troisième portion (Ox30s, Ox70s) présentant, en projection sur le plan de base (XY), une surface non nulle,
- une gravure anisotrope principale du film d'oxyde (90), par plasma, la gravure anisotrope principale étant effectuée de manière à :
- présenter une direction privilégiée (Z) perpendiculaire au plan de base (XY),
- graver ladite deuxième portion (Ox41s, Ox60s) et une partie au moins de la couche diélectrique (40) située sous la deuxième portion (Ox41s, Ox60s),
- être stoppée avant de graver :
- ladite structure (30) en un matériau semi-conducteur et,
- les portions (41) de couche diélectrique (40) sur lesquelles l'au moins une première portion du film d'oxyde (Ox41f) a été formée lors de l'étape d'oxydation principale,
la séquence étant réitérée jusqu'au retrait complet de la couche diélectrique (40) située sur les flancs (32) de ladite structure (30) en un matériau semi-conducteur.

2. Procédé selon la revendication précédente, dans lequel la gravure anisotrope principale du film d'oxyde (90), par plasma, utilise une chimie fluorocarbonée.

3. Procédé selon l'une quelconque des revendications précédentes, dans lequel ladite structure (30) forme au moins un Fin d'un transistor de type FinFET.

4. Procédé selon l'une quelconque des revendications précédentes, dans lequel ladite structure (30) est surmontée d'un motif de grille (130) présentant des flancs (131) recouverts par la couche diélectrique (40), le motif de grille (130) étant surmonté d'un masque dur (150) dont l'épaisseur e₁₅₀ est supérieure ou égale à l'épaisseur e₃₀ de ladite structure (30), les épaisseurs e₁₅₀ et e₃₀ étant prises selon ladite direction privilégiée (Z).

5. Procédé selon l'une quelconque des revendications précédentes, dans lequel l'oxydation principale est effectuée dans un réacteur de gravure plasma et ladite gravure anisotrope principale est effectuée dans le même réacteur de gravure plasma.

6. Procédé selon l'une quelconque des revendications précédentes, dans lequel préalablement à ladite pluralité de séquences, le procédé comprend :
- une étape de dépôt de la couche diélectrique (40) de sorte à ce que la couche diélectrique (40) recouvre les flancs (32) et la face (31) de ladite structure (30),
- une étape de gravure initiale, réalisée de manière anisotrope selon ladite direction privilégiée (Z) de sorte à retirer une portion au moins de la couche diélectrique (40) située sur une portion moins de la face (31) de ladite structure (30), la gravure initiale étant stoppée avant de consommer la face (31) de la structure (30).

7. Procédé selon la revendication précédente, dans lequel après l'étape de dépôt de la couche diélectrique (40) et avant l'étape de gravure initiale, le procédé comprend une étape d'oxydation initiale, effectuée de sorte à former un film d'oxyde initial (80) sur toute la surface de la couche diélectrique (40) et de préférence, dans lequel l'étape de gravure initiale est stoppée avant de consommer toute l'épaisseur de portions du film d'oxyde initial (80) situées sur des surfaces de la couche diélectrique (40) s'étendant des plans perpendiculaires (YZ, ZX) au plan de base (XY).

8. Procédé selon l'une quelconque des trois revendications précédentes, dans lequel l'étape de gravure initiale est une gravure plasma basée sur une chimie fluorée, de préférence une chimie fluorocarbonée, et de préférence une chimie à base de CxHyFz diluée avec l'une ou plusieurs parmi les espèces suivantes : l'argon, hélium, l'azote, l'oxygène.

9. Procédé selon l'une quelconque des revendications précédentes, dans lequel préalablement à ladite pluralité de séquences, la couche diélectrique (40) recouvre les flancs (32) de ladite structure (30) et de préférence dans lequel lors de ladite étape d'oxydation principale, l'au moins une troisième portion (Ox30s) du film d'oxyde (90) est formée par oxydation de ladite face (31) de la structure (30), la composition du deuxième film d'oxyde (Ox41s) étant différente de la composition du troisième film d'oxyde (Ox30s) et ladite gravure anisotrope principale étant configurée de manière à graver plus rapidement le deuxième film d'oxyde (Ox41s) que le troisième film d'oxyde (Ox30s).

10. Procédé selon la revendication précédente, dans lequel la composition du deuxième film d'oxyde (Ox41s) est du SiₓO_{y}N_{z}Fₜ et la composition du troisième portion (Ox30s) du film d'oxyde (90) est du SiₓO_{y}F_{z}, x, y, z et t étant des entiers.

11. Procédé selon l'une quelconque des deux revendications précédentes, dans lequel la gravure anisotrope principale du film d'oxyde (90) est effectuée de manière à s'arrêter avant de graver toute l'épaisseur de ladite troisième portion (Ox30s) du film d'oxyde (90).

12. Procédé selon l'une quelconque revendication 1 à 8, dans lequel chaque séquence comprend, avant ladite oxydation principale :
une gravure préalable de la couche diélectrique (40), anisotrope, par plasma, en utilisant une chimie comprenant au moins:
- au moins une chimie fluorocarbonée comprenant un premier composé, le premier composé étant à base de fluor (F) et
- au moins un deuxième composé pris parmi le Si_{w}Cl_{(2w+2)} et le Si_{w}F_{(2w+2)} w, x, y et z étant des entiers non nuls,
- de l'oxygène (O),
la gravure préalable étant effectuée de manière à :
- générer un bombardement ionique dirigé principalement selon ladite direction privilégiée (Z),
- réguler la quantité de l'au moins un premier composé pour consommer tout le composé à base de fluor lors de cette première gravure de manière à interrompre la première gravure après avoir consommé une partie au moins (41') de la couche diélectrique (40) située sur les flancs (32, 32) de la structure (30),
- déposer une première couche d'oxyde de protection (60), d'épaisseur e₆₀, à la surface de portions de la couche diélectrique (40) présentant, en projection sur le plan de base (XY), une surface non nulle,
- déposer une deuxième couche d'oxyde de protection (70), d'épaisseur e₇₀, à la surface de ladite face (31), l'épaisseur e₇₀ étant supérieure à l'épaisseur e₆₀, du fait d'une différence de composition de la première couche d'oxyde de protection (60) et de la deuxième couche d'oxyde de protection (70),
ladite gravure anisotrope principale étant effectuée de sorte à :
- graver entièrement la première couche d'oxyde de protection (60),
- être stoppée avant de graver entièrement toute l'épaisseur e₇₀ₐ de la deuxième couche d'oxyde de protection (70), ou tout au moins avant de graver ladite structure (30) en un matériau semiconducteur située sous la deuxième couche d'oxyde de protection (70).

13. Procédé selon la revendication précédente, dans lequel ledit premier composé à base de fluor (F) de la chimie utilisée pour l'étape de gravure préalable provient, de préférence intégralement, de la chimie utilisée lors de ladite étape de gravure initiale.

14. Procédé de réalisation d'un transistor FinFET (100) surmontant un substrat de support (10), le transistor FinFET (100) comprenant une grille (130) et au moins un canal (110) traversant la grille (130), le canal (110) s'étendant depuis un flanc de la grille (130) pour former au moins une structure (30) de préférence en un matériau semi-conducteur, ladite structure (30) présentant une face (31) supérieure et au moins deux flancs (32, 32), le procédé comprenant :
- le dépôt d'une couche diélectrique (40) recouvrant la grille (130) et ladite structure (30),
- la gravure de la couche diélectrique (40) en mettant en oeuvre le procédé selon l'une quelconque des revendications précédentes, de manière à retirer complètement la couche diélectrique (40) située sur la structure (30) formée par le canal (110).

15. Procédé selon la revendication précédente dans lequel le transistor (100) présente un masque dur (150) recouvrant un sommet de la grille (130), la couche diélectrique (40) étant déposée sur le masque dur (150), le masque dur (150) présentant une épaisseur e₁₅₀, tel que e₁₅₀ ≥ e₃₀, e₃₀ étant l'épaisseur de la structure (30), et de préférence e₁₅₀ ≥ 1.2 x e₃₀.

## Patentansprüche

1. Verfahren zum Ätzen einer dielektrischen Schicht (40), die mindestens teilweise eine Flanke (32, 32) von mindestens einer Struktur (30) aus einem Halbleitermaterial bedeckt, wobei sich die Flanken (32, 32) in Ebenen (YZ, ZX) senkrecht zu einer Grundebene (XY) erstrecken, auf der die Struktur (30) ruht, wobei die Struktur (30) mindestens eine Fläche (31) aufweist, die nicht senkrecht zur Grundebene (XY) ist,
**dadurch gekennzeichnet, dass** es eine Vielzahl von Sequenzen umfasst, die jeweils mindestens die folgenden aufeinanderfolgenden Schritte umfassen, und in der, vorgängig zur Vielzahl von Sequenzen, die dielektrische Schicht (40) die Flanken (32, 32) der Struktur bedeckt, und mindestens ein Abschnitt der Fläche (31) der Struktur (30) nicht von der dielektrischen Schicht (40) bedeckt ist:
- eine Hauptoxidation, insbesondere der dielektrischen Schicht (40), um einen Oxidfilm (90) zu bilden, der die Struktur (30) bedeckt, wobei der Oxidfilm (90) mindestens aufweist:
• mindestens einen ersten Abschnitt (Ox41f), der auf der Oberfläche der dielektrischen Schicht (40) gebildet ist, und sich in einer Ebene (YZ, ZX) senkrecht zur Grundebene (XY) erstreckt,
• mindestens einen zweiten Abschnitt (Ox41s, Ox141s, Ox60s), der auf der dielektrischen Schicht (40) gebildet ist, und in Projektion auf die Grundebene (XY) eine Oberfläche ungleich null aufweist,
• mindestens einen dritten Abschnitt (Ox30s, Ox70s), der auf dem Abschnitt der Fläche (31) gebildet ist, der nicht von der dielektrischen Schicht (40) bedeckt ist, vorgängig zur Vielzahl von Sequenzen, wobei der mindestens eine dritte Abschnitt (Ox30s, Ox70s) in Projektion auf die Grundebene (XY) eine Oberfläche ungleich null aufweist,
- eine anisotrope Hauptätzung des Oxidfilms (90) durch Plasma, wobei die anisotrope Hauptätzung durchgeführt wird, zum:
• Aufweisen einer Vorzugsrichtung (Z) senkrecht zur Grundebene (XY),
• Ätzen des zweiten Abschnitts (Ox41s, Ox60s) und mindestens eines Teils der dielektrischen Schicht (40), die unter dem zweiten Abschnitt (Ox41s, Ox60s) angeordnet ist,
• gestoppt werden vor dem Ätzen:
o der Struktur (30) aus einem Halbleitermaterial und,
o der Abschnitte (41) der dielektrischen Schicht (40), auf denen mindestens ein erster Abschnitt des Oxidfilms (Ox41f) während des Schritts der Hauptoxidation gebildet wurde,
wobei die Sequenz wiederholt wird, bis die dielektrische Schicht (40), die an den Flanken (32) der Struktur (30) aus einem Halbleitermaterial angeordnet ist, vollständig geschwunden ist.

2. Verfahren nach dem vorhergehenden Anspruch, wobei die anisotrope Hauptätzung des Oxidfilms (90) durch Plasma eine Fluorkohlenstoffchemie verwendet.

3. Verfahren nach einem der vorhergehenden Ansprüche, wobei die Struktur (30) mindestens eine Finne eines FinFET-Transistors bildet.

4. Verfahren nach einem der vorhergehenden Ansprüche, wobei die Struktur (30) von einem Gate-Muster (130) überragt wird, das Flanken (131) aufweist, die von der dielektrischen Schicht (40) bedeckt sind, wobei das Gate-Muster (130) von einer Hartmaske (150) überragt wird, dessen Dicke e₁₅₀ größer oder gleich der Dicke e₃₀ der Struktur (30) ist, wobei die Dicken e₁₅₀ und e₃₀ in der Vorzugsrichtung (Z) abgenommen werden.

5. Verfahren nach einem der vorhergehenden Ansprüche, wobei die Hauptoxidation in einem Plasmaätzreaktor durchgeführt wird und die anisotrope Hauptätzung in demselben Plasmaätzreaktor durchgeführt wird.

6. Verfahren nach einem der vorhergehenden Ansprüche, wobei das Verfahren, vorgängig zur Vielzahl von Sequenzen, umfasst:
- einen Schritt des Abscheidens der dielektrischen Schicht (40), so dass die dielektrische Schicht (40) die Flanken (32) und die Fläche (31) der Struktur (30) bedeckt,
- einen Schritt der initialen Ätzung, der in der Vorzugsrichtung (Z) anisotrop realisiert wird, zum Entfernen von mindestens einem Abschnitt der dielektrischen Schicht (40), der auf einem geringeren Abschnitt der Fläche (31) der Struktur (30) angeordnet ist, wobei die initiale Ätzung gestoppt wird, bevor die Fläche (31) der Struktur (30) verbraucht ist.

7. Verfahren nach dem vorhergehenden Anspruch, wobei nach dem Schritt des Abscheidens der dielektrischen Schicht (40) und vor dem Schritt der initialen Ätzung das Verfahren einen Schritt der initialen Oxidation umfasst, der durchgeführt wird, zum Bilden eines initialen Oxidfilms (80) über der gesamten Oberfläche der dielektrischen Schicht (40), und vorzugsweise im Schritt der initialen Ätzung gestoppt wird, bevor die gesamte Dicke von Abschnitten des initialen Oxidfilms (80) verbraucht ist, die auf Oberflächen der dielektrischen Schicht (40) angeordnet sind, die sich von den Ebenen (YZ, ZX) senkrecht zur Grundebene (XY) erstrecken.

8. Verfahren nach einem der drei vorhergehenden Ansprüche, wobei der Schritt der initiale Ätzung eine Plasmaätzung auf der Grundlage einer Fluorchemie ist, vorzugsweise einer Fluorkohlenstoffchemie, und vorzugsweise einer Chemie auf der Basis von CxHyFz verdünnt mit einer oder mehreren der folgenden Spezies: Argon, Helium, Stickstoff, Sauerstoff.

9. Verfahren nach einem der vorhergehenden Ansprüche, wobei vorgängig zur Vielzahl von Sequenzen die dielektrische Schicht (40) die Flanken (32) der Struktur (30) bedeckt und vorzugsweise im Schritt der initialen Oxidation der mindestens eine dritte Abschnitt (Ox30s) des Oxidfilms (90) durch Oxidation der Fläche (31) der Struktur (30) gebildet wird, wobei sich die Zusammensetzung des zweiten Oxidfilms (Ox41s) von der Zusammensetzung des dritten Oxidfilms (Ox30s) unterscheidet, und die anisotrope Hauptätzung so konfiguriert ist, dass sie den zweiten Oxidfilm (Ox41s) schneller ätzt als den dritten Oxidfilm (Ox30s).

10. Verfahren nach dem vorhergehenden Anspruch, wobei die Zusammensetzung des zweiten Oxidfilms (Ox41s) SiₓO_{y}N_{z}Fₜ ist und die Zusammensetzung des dritten Abschnitts (Ox30s) des Oxidfilms (90) SiₓO_{y}F_{z} ist, wobei x, y, z und t ganze Zahlen sind.

11. Verfahren nach einem der zwei vorhergehenden Ansprüche, wobei die anisotrope Hauptätzung des Oxidfilms (90) so durchgeführt wird, dass sie vor dem Ätzen der gesamten Dicke des dritten Abschnitts (Ox30s) des Oxidfilms (90) aufhört.

12. Verfahren nach einem der Ansprüche 1 bis 8, wobei jede Sequenz, vor der Hauptoxidation, umfasst:
eine vorgängige anisotrope Ätzung der dielektrischen Schicht (40) durch Plasma, unter Verwendung einer Chemie, die mindestens umfasst:
- mindestens eine Fluorkohlenstoffchemie, die eine erste Verbindung umfasst, wobei die erste Verbindung auf der Basis von Fluor (F) ist, und
- mindestens eine zweite Verbindung, die aus Si_{w}Cl_{(2w+2)} und Si_{w}F_{(2w+2)} ausgewählt wird, wobei w, x, y und z ganze Zahlen ungleich null sind,
- Sauerstoff (O),
wobei die vorgängige Ätzung durchgeführt wird, zum:
- Erzeugen eines hauptsächlich in der Vorzugsrichtung (Z) gerichteten Ionenbeschusses,
- Regulieren der Menge der mindestens einen ersten Verbindung, um die gesamte Verbindung auf der Basis von Fluor während dieser ersten Ätzung zu verbrauchen, so dass die erste Ätzung, nachdem sie mindestens einen Teil (41') der dielektrischen Schicht (40) verbraucht hat, die an den Flanken (32, 32) der Struktur (30) angeordnet ist, unterbrochen wird,
- Abscheiden einer ersten Schutzoxidschicht (60) der Dicke e₆₀ auf die Oberfläche der Abschnitte der dielektrischen Schicht (40), die in Projektion auf die Grundebene (XY) eine Oberfläche ungleich null aufweist,
- Abscheiden einer zweiten Schutzoxidschicht (70) der Dicke e₇₀ auf die Oberfläche der Fläche (31), wobei die Dicke e₇₀ größer ist als die Dicke e₆₀, aufgrund eines Unterschieds in der Zusammensetzung der ersten Schutzoxidschicht (60) und der zweiten Schutzoxidschicht (70),
wobei die anisotrope Hauptätzung durchgeführt wird, zum:
- vollständigen Ätzen der ersten Schutzoxidschicht (60),
- gestoppt werden vor dem vollständigen Ätzen der gesamten Dicke e₇₀ₐ der zweiten Schutzoxidschicht (70), oder mindestens vor dem Ätzen der Struktur (30) aus einem Halbleitermaterial, die unter der zweiten Schutzoxidschicht (70) angeordnet ist.

13. Verfahren nach dem vorhergehenden Anspruch, wobei die erste Verbindung auf der Basis von Fluor (F) der Chemie, die für den Schritt der vorgängigen Ätzung verwendet wird, vorzugsweise vollständig aus der Chemie stammt, die im Schritt der initialen Ätzung verwendet wird.

14. Verfahren zur Realisierung eines FinFET-Transistors (100), der ein Trägersubstrat (10) überragt, wobei der FinFET-Transistor (100) ein Gate (130) umfasst und mindestens einen Kanal (110), der das Gate (130) durchquert, der Kanal (110) sich von einer Flanke des Gates (130) erstreckt, um mindestens eine Struktur (30) vorzugsweise aus einem Halbleitermaterial zu bilden, wobei die Struktur (30) eine obere Fläche (31) und mindestens zwei Flanken aufweist (32, 32), wobei das Verfahren umfasst:
- das Abscheiden einer dielektrischen Schicht (40), die das Gate (130) und die Struktur (30) bedeckt,
- die Ätzung der dielektrischen Schicht (40) durch Durchführung des Verfahrens nach einem der vorhergehenden Ansprüche, um die dielektrische Schicht (40), die auf der durch den Kanal (110) gebildeten Struktur (30) angeordnet ist, vollständig zu entfernen.

15. Verfahren nach dem vorhergehenden Anspruch, wobei der Transistor (100) eine Hartmaske (150) aufweist, die eine Oberseite des Gates (130) bedeckt, wobei die dielektrische Schicht (40) auf der Hartmaske (150) abgeschieden ist, wobei die Hartmaske (150) eine Dicke e₁₅₀ aufweist, so dass e₁₅₀ ≥ e₃₀, wobei e₃₀ die Dicke der Struktur (30) ist, und vorzugsweise e₁₅₀ ≥ 1.2 x e₃₀ ist.

## Claims

1. A method for etching a dielectric layer (40) at least partially covering a side (32, 32) of at least one structure (30) made of a semiconductor material, the sides (32, 32) extending in planes (YZ, ZX) perpendicular to a base plane (XY) on which the structure (30) rests, the structure (30) having at least one face (31) not perpendicular to the base plane (XY)
**characterised in that** it comprises a plurality of sequences each comprising at least the following successive steps, and wherein prior to said plurality of sequences, the dielectric layer (40) covers the sides (32, 32) of said structure, and at least a portion of the face (31) of said structure (30) is not covered by the dielectric layer (40):
- a main oxidation, in particular of the dielectric layer (40), so as to form an oxide film (90) covering the structure (30), the oxide film (90) having at least:
• at least one first portion (Ox41f) formed on the surface of the dielectric layer (40) and extending in a plane (YZ, ZX) perpendicular to the base plane (XY),
• at least one second portion (Ox41s, Ox141s, Ox60s) formed on the dielectric layer (40) and having, in projection on the base plane (XY), a non-zero surface,
• at least one third portion (Ox30s, Ox70s) formed on said portion of the face (31) which is not covered by the dielectric layer (40) prior to said plurality of sequences, the at least one third portion (Ox30s, Ox70s) having, in projection on the base plane (XY), a non-zero surface,
- a main anisotropic etching of the oxide film (90), by plasma, the main anisotropic etching being carried out in such a way as to:
• have a preferred direction (Z) perpendicular to the base plane (XY),
• etch said second portion (Ox41s, Ox60s) and at least part of the dielectric layer (40) located under the second portion (Ox41s, Ox60s),
• be stopped before etching:
∘ said structure (30) made of a semiconductor material and,
∘ the portions (41) of dielectric layer (40) on which the at least one first portion of the oxide film (Ox41f) was formed during the main oxidation step,
the sequence being repeated until the complete removal of the dielectric layer (40) located on the sides (32) of said structure (30) made of a semiconductor material.

2. The method according to the preceding claim, wherein the main anisotropic etching of the oxide film (90), by plasma, uses a fluorocarbon chemistry.

3. The method according to any one of the preceding claims, wherein said structure (30) forms at least one Fin of a FinFET type transistor.

4. The method according to any one of the preceding claims, wherein said structure (30) is surmounted by a gate pattern (130) having sides (131) covered by the dielectric layer (40), the gate pattern (130) being surmounted by a hard mask (150) the thickness e₁₅₀ of which is greater than or equal to the thickness e₃₀ of said structure (30), the thicknesses e₁₅₀ and e₃₀ being taken in said preferred direction (Z).

5. The method according to any one of the preceding claims, wherein the main oxidation is carried out in a plasma etching reactor and said main anisotropic etching is carried out in the same plasma etching reactor.

6. The method according to any one of the preceding claims, wherein prior to said plurality of sequences, the method comprises:
- a step of depositing the dielectric layer (40) so that the dielectric layer (40) covers the sides (32) and the face (31) of said structure (30),
- an initial etching step, performed anisotropically along said preferred direction (Z) so as to remove at least a portion of the dielectric layer (40) located on at least a portion of the face (31) of said structure (30), the initial etching being stopped before consuming the face (31) of the structure (30).

7. The method according to the preceding claim, wherein after the step of depositing the dielectric layer (40) and before the initial etching step, the method comprises an initial oxidation step, carried out so as to form an initial oxide film (80) over the entire surface of the dielectric layer (40) and preferably, wherein the initial etching step is stopped before consuming the entire thickness of portions of the initial oxide film (80) located on surfaces of the dielectric layer (40) extending from the planes (YZ, ZX) perpendicular to the base plane (XY).

8. The method according to any one of the three preceding claims, wherein the initial etching step is a plasma etching based on a fluorinated chemistry, preferably a fluorocarbon chemistry, and preferably a chemistry based on CxHyFz diluted with the one or more of the following species: argon, helium, nitrogen, oxygen.

9. The method according to any one of the preceding claims, wherein prior to said plurality of sequences, the dielectric layer (40) covers the sides (32) of said structure (30) and preferably wherein during said main oxidation step, the at least one third portion (Ox30s) of the oxide film (90) is formed by oxidation of said face (31) of the structure (30), the composition of the second oxide film (Ox41s) being different from the composition of the third oxide film (Ox30s) and said main anisotropic etching being configured so as to etch the second oxide film (Ox41s) faster than the third oxide film (Ox30s).

10. The method according to the preceding claim, wherein the composition of the second oxide film (Ox41s) is SiₓO_{y}N_{z}Fₜ and the composition of the third portion (Ox30s) of the oxide film (90) is SiₓO_{y}F_{z}, x, y, z and t being integers.

11. The method according to any one of the two preceding claims, wherein the main anisotropic etching of the oxide film (90) is carried out so as to stop before etching the entire thickness of said third portion (Ox30s) of the oxide film (90).

12. The method according to any one of claims 1 to 8, wherein each sequence comprises, before said main oxidation:
a preliminary anisotropic etching of the dielectric layer (40), by plasma, using a chemistry comprising at least:
- at least one fluorocarbon chemistry comprising a first compound, the first compound being based on fluorine (F) and
- at least one second compound taken from Si_{w}Cl_{(2w+2)} and Si_{w}F_{(2w+2)} w, x, y and z being non-zero integers,
- oxygen (O),
the preliminary etching being carried out in such a way as to:
- generate an ion bombardment directed mainly along said preferred direction (Z),
- regulate the amount of the at least one first compound to consume all the fluorine-based compound during this first etching so as to interrupt the first etching after having consumed at least part (41') of the dielectric layer (40) located on the sides (32, 32) of the structure (30),
- deposit a first layer of protective oxide (60), of thickness e₆₀, on the surface of portions of the dielectric layer (40) having, in projection on the base plane (XY), a non-zero surface,
- deposit a second layer of protective oxide (70), of thickness e₇₀, on the surface of said face (31), the thickness e₇₀ being greater than the thickness e₆₀, due to a difference in composition of the first protective oxide layer (60) and the second protective oxide layer (70),
said main anisotropic etching being carried out so as to:
- completely etch the first protective oxide layer (60),
- be stopped before completely etching the entire thickness e₇₀ₐ of the second protective oxide layer (70), or at least before etching said structure (30) made of a semiconductor material located under the second protective oxide layer (70).

13. The method according to the preceding claim, wherein said first fluorine-based compound (F) of the chemistry used for the preliminary etching step comes, preferably entirely, from the chemistry used during said initial etching step.

14. A method for producing a FinFET transistor (100) surmounting a support substrate (10), the FinFET transistor (100) comprising a gate (130) and at least one channel (110) passing through the gate (130), the channel (110) extending from a side of the gate (130) to form at least one structure (30) preferably made of a semiconductor material, said structure (30) having an upper face (31) and at least two sides (32, 32), the method comprising:
- depositing a dielectric layer (40) covering the gate (130) and said structure (30),
- etching the dielectric layer (40) by implementing the method according to any one of the preceding claims, so as to completely remove the dielectric layer (40) located on the structure (30) formed by the channel (110).

15. The method according to the preceding claim, wherein the transistor (100) has a hard mask (150) covering a top of the gate (130), the dielectric layer (40) being deposited on the hard mask (150), the hard mask (150) having a thickness e₁₅₀, such that e₁₅₀ ≥ e₃₀, e₃₀ being the thickness of the structure (30), and preferably e₁₅₀ ≥ 1.2 × e₃₀.
